# EUROPEAN PATENT SPECIFICATION

(11) **EP 4 487 331 B1**
(45) Date of publication and mention of the grant of the patent: **22.07.2026**
(21) Application number: 23708461.1
(22) Date of filing: 28.02.2023
(51) Int. Cl.: G11C 13/00

(54) **MEMRISTIVE STRUCTURE, MEMRISTIVE ARRAY, AND METHODS THEREOF**
MEMRISTIVE STRUKTUR, MEMRISTIVE ANORDNUNG UND VERFAHREN DAFÜR
STRUCTURE MEMRISTIVE, RÉSEAU MEMRISTIF, ET PROCÉDÉS ASSOCIÉS

(30) Priority: 01.03.2022 DE 102022104831
(43) Date of publication of application: 08.01.2025
(73) Proprietor: TechIFab GmbH, 01454 Radeberg (DE)
(72) Inventor: SCHMIDT, Heidemarie, 01069 Dresden (DE); DU, Nan, 07745 Jena (DE); SKORUPA, Ilona, 01108 Dresden (DE)
(74) Representative: Ehrler Patent
(86) International application number: PCT/EP2023/054996
(87) International publication number: WO 2023/165981

(56) References cited:
- US-A- 6 072 716
- US-A1- 2011 080 767
- US-A1- 2019 122 730

## Description

### Technical Field

Various aspects relate to a memristive structure, a memristive array including a plurality of memristive structures, and methods thereof, e.g., methods for forming a memristive structure, e.g., methods for forming a memristive structure array.

### Background

In general, various data processing applications may rely on transistor technologies. However, it was found that resistor arrays may be useful for some data processing applications as well. Such resistor-based technologies were further developed to allow for a selective reconfiguration of an electric resistance of resistors. Such devices having a non-volatile, reconfigurable electric resistance may be referred to as memristive devices or memristors, for example. Memristor crossbar arrays were developed to replace transistors and memory cells in some data processing and data storage applications. However, an occurrence of leakage currents in memristor based crossbar arrays may limit a scalability of such structures. Therefore, several types of memristors with nonlinear resistance behavior have been proposed to reduce leakage currents when reconfiguring and reading selective memristors over nonselective memristors. These include so-called complementary resistance switches, which include two memristive structures connected in series, wherein a disadvantage of this technology may be that the state of the complementary resistance can be only read out destructively and, therefore, the complementary resistance switch has to be rewritten after readout. An approach for a nondestructive readout of a state of a complementary resistive switch may be based on capacitance measurements. A complementary resistive switch may include a two-layer memristive structure with strong nonlinear resistive behavior and a single-layer memristive structure with strong nonlinear resistive behavior. US 6 072 716 A describes a memory structure including two electrodes and therebetween a polymer memory material that has a particulate conductive or semiconductive material dispersed therein, wherein the memory structure exhibits a reversible memory switching behavior. US 2019 / 0 122 730 A1 discloses a memristive structure including a memory structure between two electrodes, wherein the memory structure is a stack of three planar layers, namely a planar bismuth ferrite layer disposed between two planar titanium-doped bismuth ferrite layers.

### Summary

The present invention is defined by a memristive memory array according to independent claim 1. Advantageous embodiments are defined in the dependent claims.

### Brief Description of the Drawings

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:
FIGS.1A to 1D schematically show various aspects of a memristive structure;
FIGS.2A and 2B schematically show various aspects of a memristive structure;
FIGS.3A to 3D schematically show various aspects of a memristive structure;
FIGS.4A to 4F schematically show various aspects of a memristive structure;
FIGS.5A to 5D schematically show various aspects of a crossbar array to address a plurality of memristive structures;
FIGS.5E and 5F schematically show various aspects of an array to address a plurality of memristive structures;
FIGS.6A-I, 6A-II, and 6A-III schematically show various aspects of a crossbar array to address a plurality of memristive structures;
FIGS.6B to 6G schematically show various aspects of a crossbar array to address a plurality of memristive structures;
FIGS.7A and 7B schematically show various aspects of a memristive structure;
FIGS.8A to 8C schematically show various aspects of a memristive structure and a manufacturing thereof;
FIGS.9A and 9B schematically show various aspects of electrical characteristics of different types of memristive structures;
FIGS.10A and 10B schematically show various aspects of electrical characteristics of different types of memristive structures;
FIGS.11A and 11B schematically show various aspects of electrical characteristics of different types of memristive structures;
FIGS.12A and 12B schematically show various aspects of electrical characteristics of different types of memristive structures;
FIG. 13 schematically shows various aspects of electrical characteristics of a memristive structures;
FIG.14A and FIG.14B show measurements of a manufactured memristive structure in a memristive crossbar array;
FIG.15 schematically shows various aspects of forming memristive structures of a memristive crossbar array; and
FIGS.16A to 16F show schematically various aspects of a memristive structure of a memristive array.

### Description

The following detailed description refers to the accompanying drawings that show, by way of illustration, specific details and aspects in which the invention may be practiced. These aspects are described in sufficient detail to enable those skilled in the art to practice the invention. Other aspects may be utilized and structural, logical, and electrical changes may be made without departing from the scope of the invention. The various aspects are not necessarily mutually exclusive, as some aspects can be combined with one or more other aspects to form new aspects. Various aspects are described in connection with methods and various aspects are described in connection with devices (e.g., arrangements). However, it may be understood that aspects described in connection with methods may similarly apply to the devices, and vice versa.

The terms "at least one" and "one or more" may be understood to include any integer number greater than or equal to one, i.e., one, two, three, four, [...], etc. The term "a plurality" may be understood to include any integer number greater than or equal to two, i.e., two, three, four, five, [...], etc. The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of listed elements.

The phrase "unambiguously assigned" may be used herein to mean a one-to-one-assignment (e.g., allocation, e.g., correspondence) or a bijective assignment. As an example, a first element being unambiguously assigned to a second element may include that the second element is unambiguously assigned to the first element. As another example, a first group of elements being unambiguously assigned to a second group of element may include that each element of the first group of elements is unambiguously assigned to a corresponding element of the second group of elements and that that corresponding element of the second group of elements is unambiguously assigned to the element of the first group of elements.

The term "coupled" may be used herein with respect to nodes, circuit elements, and the like, to mean a, e.g. direct or indirect, connection and/or interaction. Several elements may, for example, be coupled together along an interaction chain (e.g., an electrically conductive path), along which the interaction (e.g., electrical charges) may be transmitted. For example, two elements coupled together may interact with each other.

The term "connected" or "connection" may be used herein with respect to nodes, circuit elements, and the like, to mean electrically connected, which may include a direct connection or an indirect connection, wherein an indirect connection may only include additional structures in the current path that do not influence the substantial functioning of the described circuit or device. The term "electrically conductively connected" that is used herein to describe an electrical connection between one or more terminals, nodes, regions, contacts, etc., may be understood as an electrically conductive connection with, for example, ohmic behavior, e.g., provided by a metal or degenerate semiconductor in absence of p-n junctions in the current path. The term "electrically conductively connected" may be also referred to as "galvanically connected."

In some aspects, two physical and/or chemical properties (e.g., an electrical voltage, an electrical current, an electrical conductance, a thickness, an electrical conductivity, a doping concentration, as examples) may be compared with one another by relative terms such as "greater", "higher", "lower", "less", or "equal", for example. It is understood that, in some aspects, a comparison may include a sign (positive or negative) of a value representing the physical and/or chemical properties or, in other aspects, the absolute values are considered for the comparison. However, a comparison of measurement values representing a physical and/or chemical property may usually include a measurement of such measurement values by the same measurement principle or at least by comparable measurement principles.

According to various aspects, a memristive structure in an array of memristive structures (e.g., within a crossbar array) may be addressable, e.g. by being unambiguously assigned to a logic address. The addressability and the logic addresses may be provided by the architecture of the control lines connected to a respective memristive structure. In a crossbar array, two sets of control lines (e.g., a set of word-lines and a set of bit-lines) may be utilized to address an array of memristive structures. According to various aspects, an analog memristive structure may reside in one of various resistance states (also referred to as memristive states) associated therewith. As an example, the actual electrical resistance (or conductivity) associated with a memristive structure can be determined via a read operation to evaluate in which of the distinct resistance states the memristive structure is residing in. As another example, the actual electrical resistance (or conductivity) associated with a memristive structure can be utilized in a neuronal network configuration to influence a data or signal processing.

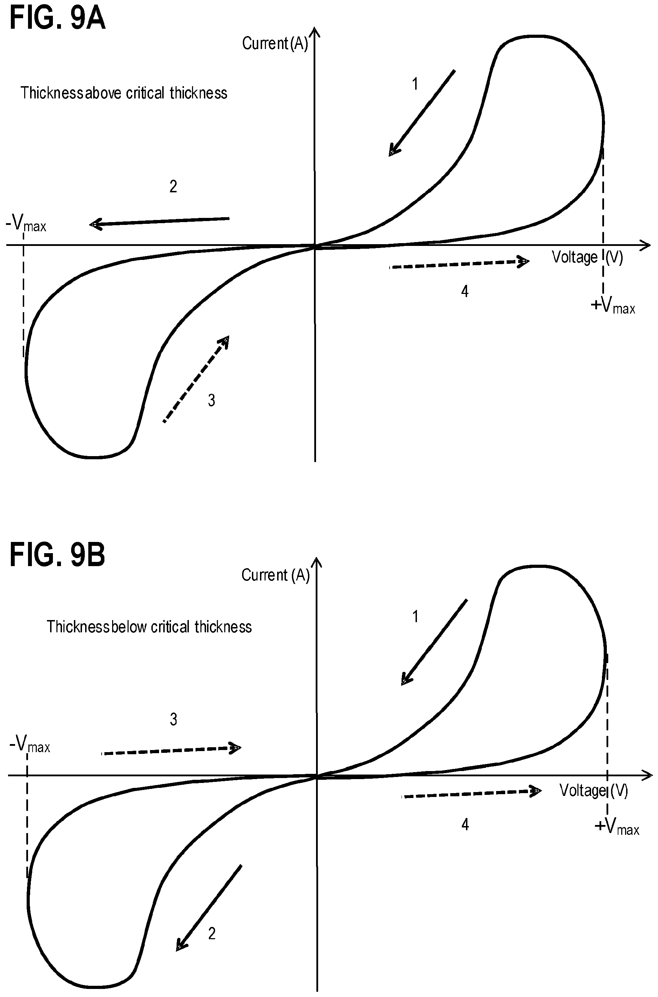

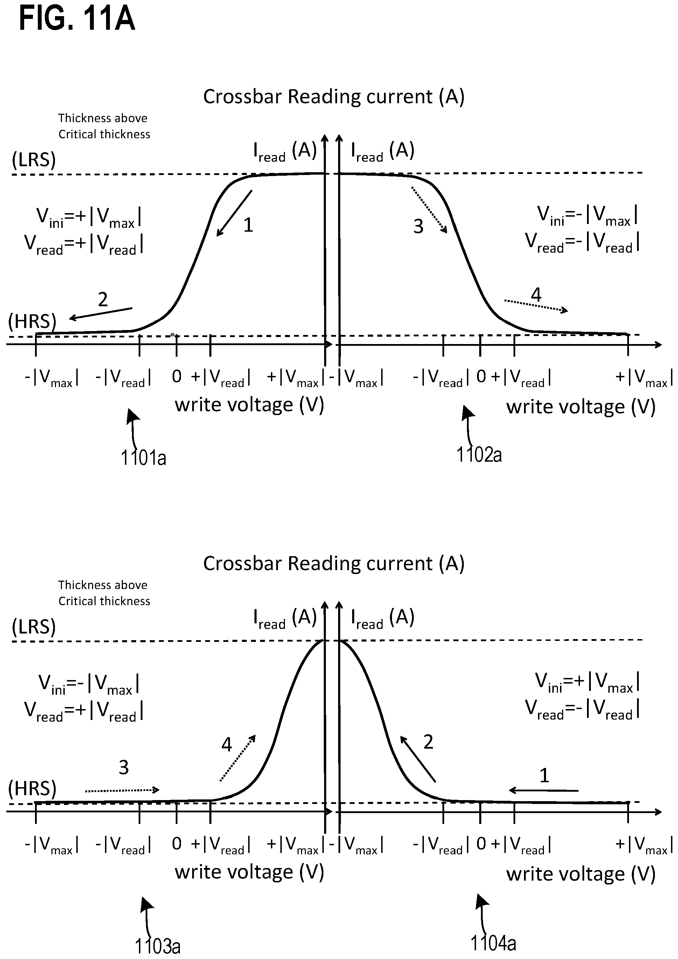

In some aspects, a plurality of memristive structures may be arranged in a crossbar configuration. In such a crossbar configuration, a memristive material portion (also referred to as memristor or memristive device) can be addressed by a corresponding cross-point formed by input-lines and output-lines of the crossbar arrangement. Neuromorphic and/or analog computing technologies, only as examples, may utilize an ideal analog switching of a memristive structure. A memristive structure (also referred to as memristive device, memristive element, resistive switch, memristor, memristor element, or memristor structure) may be regarded as an analog memristive structure in the case that the memristive structure exhibits a continuous change in current (e.g., in the read current I_{read}) when linearly ramping the applied voltage (e.g., from 0 V to +Vₘₐₓ and from +Vₘₐₓ to 0 V and from 0 V to -Vₘₐₓ and from -Vₘₐₓ to 0 V), see, for example, FIG.9A and FIG.9B. It is understood, in some aspects, that a memristive structure is analog if the IV characteristics with branch 1 and 4 in the first quadrant and branch 2 and 3 in the third quadrant are different from one another (see FIG.9A). Typically, the memristive structure is set in a well-defined resistance state by applying an initialization voltage. This resistance state can be changed by applying a write voltage. The write voltage can be varied from -|Vmax| to +|Vmax|. Typically, the resistance state can be measured by applying a small read voltage. Per definition, in some aspects, the read voltage does not change the resistance state of the memristive structure. After an initialization operation, a write voltage is applied, then the resistance state is read out with the read voltage. Before applying next write voltage a next initialization voltage is applied and the next resistance state is read out with the read voltage. The initialization voltage and the read voltage is kept the same. An applied voltage in the range from a positive voltage (>0 V) to a predefined positive voltage +Vₘₐₓ may be used as a positive write voltage and an applied voltage in the range from a negative voltage (<0 V) to a predefined negative voltage -Vₘₐₓ may be used as a negative write voltage. Positive initialization voltage and positive read voltage (see graph 1101a in FIG.11A) and negative initialization voltage and negative read voltage (see graph 1102a in FIG.11A) and write voltages of different amplitude and polarity can be applied in any order to yield a symmetrical change of the read current (see graphs 1101a, 1102a in FIG.11A). Also negative initialization voltage and positive read voltage (see graph 1103a in FIG.11A) and positive initialization voltage and negative read voltage (see graph 1104a in FIG.11A) and write voltages of different amplitude and polarity can be applied in any order to yield a symmetrical change of the read current (see graphs 1103a, 1104a in FIG.11A). An ideal analog switching may be characterized by a substantially symmetrical change in read current after applying write voltage pulses of different amplitudes in the range from -|Vₘₐₓ| to +|Vₘₐₓ| when reversing the polarity of the initialization write voltage and of the read voltage, see, for example, FIG.11A.

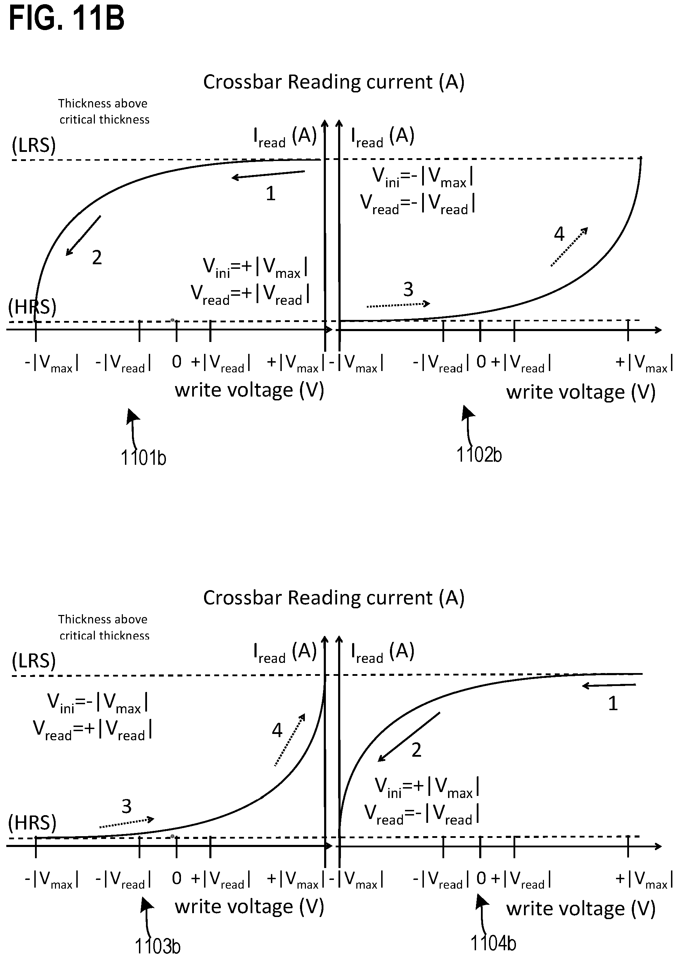

The current voltage characteristic (e.g., the I/V curves) of a memristive structure that shows an ideal analog switching may have at least one change in the curvature (e.g., from left-curved to right-curved or vice versa) see, for example, FIG.11A, wherein a non-ideal analog switching is otherwise associated with no change in the curvature, cf., FIG. 11B.

It is understood, in some aspects, that a memristive structure is analog if the IV characteristics with branch 1 and 4 in the first quadrant are different and if the IV characteristics with branch 2 and 3 in the third quadrant are same. The current voltage characteristic (e.g., the I/V curves) of a memristive structure that shows an ideal analog switching in the first quadrant may have at least one change in the curvature (e.g., from left-curved to right-curved or vice versa) for positive initialization and positive read (see graph 1101a in FIG.11A) and for positive initialization and negative read (see graph 1104a in FIG.11A), a non-ideal analog switching with branch 1 and 4 different and branch 2 and 3 same is otherwise associated with no change in the curvature, cf., for positive initialization and positive read (see graph 1101b in FIG.11B) and for positive initialization and negative read (see graph 1104b in FIG.11B). We also understand that a memristive structure is analog if the IV characteristics with branch 1 and 4 in the first quadrant the same and if the IV characteristics with branch 2 and 3 in the third quadrant are different. The current voltage characteristic (e.g., the I/V curves) of a memristive structure that shows an ideal analog switching in the third quadrant may have at least one change in the curvature (e.g., from left-curved to right-curved or vice versa) for negative initialization and negative read (see graph 1102a in FIG.11A) and for negative initialization and positive read (see graph 1103a in FIG.11A), a non-ideal analog switching with branch 1 and 4 same and branch 2 and 3 different is otherwise associated with no change in the curvature, for negative initialization and negative read (see graph 1102b in FIG.11B) and for negative initialization and positive read (see graph 1103b in FIG.11B).

According to various aspects, a memristive element may include a memristive material portion. In a relevant configuration, a memristive element (or in other words the memristive material portion) may be disposed between two electrodes. The two electrodes may be electrically conductively connected to a corresponding memristive material portion to form a memristive structure. In a crossbar array, cross-points of corresponding control lines may define a cross-point region in which a memristive element (also referred to as memristor material portion) can be disposed and addressed by the corresponding control lines. A memristive element (or in other words a memristive material portion) may be or may include one or more of the following materials and/or material combinations: Al₂O₃/TaOₓ, SiOₓ:Ag/TiOₓ, TaO, HfAl_{y}Oₓ/TaO, Pr_{0.7}Ca_{0.3}MnO₃ (PCMO), Si-In-Zn-O/ion gel, SiInZnO, SiN/TaN, SrFeO₃, only as examples.

In general, there may be approaches to fabricate a memristive array (also referred to as memristor array, memristive-device array, memristive-structure array, memristive-element array, as examples). However, conventional attempts may result always in non-ideal (e.g., asymmetric) read characteristics, see FIG.11B, e.g., without change in curvature. A memristive array in which the memristive structures show non-ideal (e.g., asymmetric) read characteristics may require complex counter measures to compensate for the problems that are caused by the non-ideal behavior. It may be favorable, if all memristive structures of a memristive array (e.g., of a memristive crossbar array) have the same or at least very similar read characteristics and, in particular, if all memristive structures of a memristive array have ideal (e.g., symmetric) read characteristics, see, for example, FIG.9A and FIG.11A. An ideal (e.g., substantially symmetric) read characteristics may have the benefit that all states that are written have a predefined resistance range associated therewith and, therefore, cause a predefined read current upon application of a read voltage.

Currently available analog memristors may not exhibit a symmetric read change in the read characteristic, therefore, a change in read out current may not be symmetric when writing with voltage pulses of different amplitudes when the polarity of the initialization voltage and of the read voltage is reversed. Therefore, such existing memristors may not be suitable for use in a crossbar structure for neuromorphic computing or for use in analog computers.

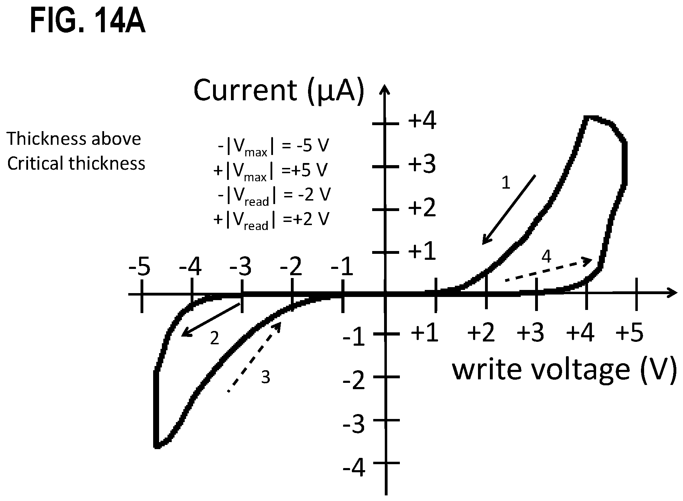

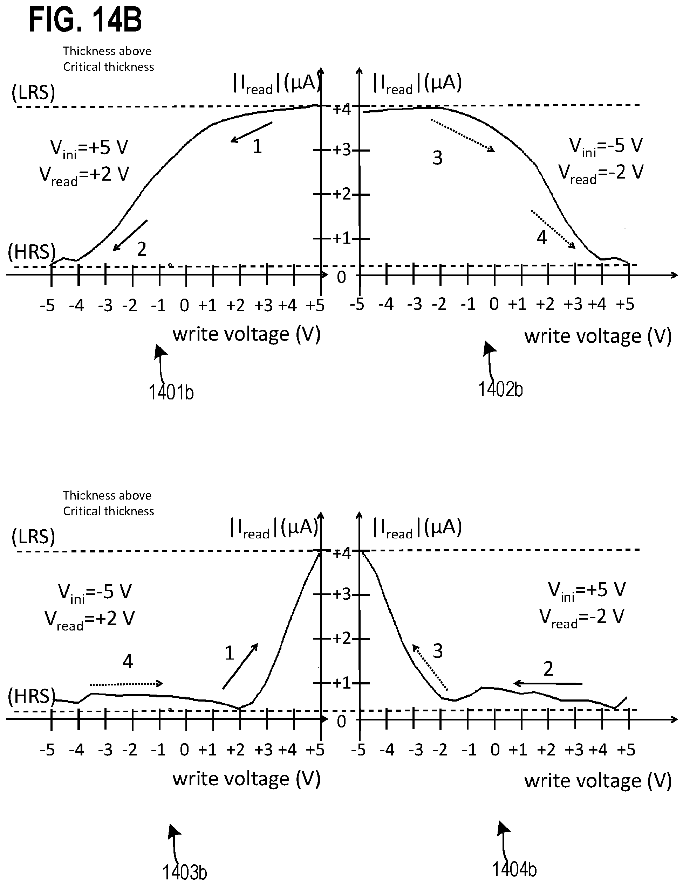

According to various aspects, it was found that a more ideal or even an ideal read characteristic can be realized for a memristive structure in a memristive array (e.g., in a memristive crossbar array) if the memristive material portion has a comparatively large thickness, e.g., a thickness of more 150 nm, e.g., more than 200 nm, or more than 250 nm, see FIG.14A and FIG.14B. Such comparatively large layer thicknesses are usually not considered to be used in memristor arrays. A drawback that may be related with such comparatively large layer thicknesses may be the complexity of manufacturing the memristors, since commonly used patterning processes (e.g., via dry or wet etching) may be less and less suitable with an increasing layer thickness.

Various aspects of the present disclosure are related to processes and integration details that allow for a successful fabrication of ideal analog memristive structures in intersection regions of a crossbar array. In particular, a crossbar array and suitable memristive structures are described herein that allow for an unambiguously addressing of analog memristive structures, wherein the analog memristive structures have an ideal (e.g., symmetric) read characteristic, see FIG.14A and FIG.14B. The memristive structures may include a memristive material portion that has a thickness greater than 150 nm and, at the same time, the effective memristive structure footprint may be preferably as small as possible. In other words, the effective memristive material portion has a comparatively large aspect ratio (the aspect ratio may be understood as a height divided by the width of a structure or portion), which according to the present invention is an aspect ratio greater than one, e.g., greater than two.

According to various aspects, a control circuit and a memristive array coupled thereto may be configured to allow for a selective addressing of one or more memristive structures in the memristive array (the memristive array may be a memristive crossbar array). It is emphasized that a selective addressing (e.g., during writing, e.g., as part of a write operation) of a selected memristive structure of a memristive array may include an application of one or more write voltage pulses to the selected memristive structure such that only the resistance of the selected memristive structure and not simultaneously also the resistance of other memristive structures of the memristive array is changed. The one or more write voltage pulses may be applied to the selected memristive structure by suppling one or more write voltage pulses to a selected word-line and a correspondingly selected bit line of the memristive array. In a memristive crossbar array, an intersection of the selected word-line and the correspondingly selected bit line are associated with the selected memristive structure. The memristive structure is located in a cross-point region in which the selected word-line crosses the correspondingly selected bit-line. It is further emphasized that a selective addressing (e.g., during reading, e.g., as part of a read operation) of a memristive structure of a memristive array (e.g., in a memristive crossbar array) may include an application of one or more read voltage pulses to the selected memristive structure such that only the resistance of the selected memristive structure can be determined and such that the determination of the resistance of the selected memristive structure is not simultaneously affected by a resistance of other memristive structures of the crossbar array. The resistance of the selected memristive structure may be, for example, measured by applying one or more read voltage pulses to the word-line and/or the bit line of the crossbar array in whose cross-point the selected memristive structure is located and by measuring the resulting read current.

Some aspects are related to enable a formation of a predefined (e.g., a constrained) electric field in a memristive structure to be operated. A memristive structure to be operated (e.g., to be written, e.g., to be read) may be referred to as a selected memristive structure. A memristive structure may be selected by applying a voltage, for example a write voltage or a read voltage, to the word-line and the bit-line of the crossbar array that corresponds to the selected memristive structure. An electric field that is created in a respective cross-point of the crossbar array during reading and/or writing of the corresponding memristive structure may be guided and/or modified by one or more techniques described herein. As an example, a formation of an electric field in a cross-point of the crossbar array may be controlled such that a possibly high electric field density is caused inside the cross-point region and such that a possibly low electric field density is caused outside the cross-point region.

In some aspects, an integration of an analog memristive structure at cross-points of a crossbar array may be more difficult with increasing thickness of the memristive material portion, and the more difficult may it be to selectively address the analog memristive structures.

In the following, various aspects of a memristive structure 100 are illustrated in schematic views. The memristive structure 100 may be, in some aspects, a memristive cross-point structure included in a memristive crossbar array 500.

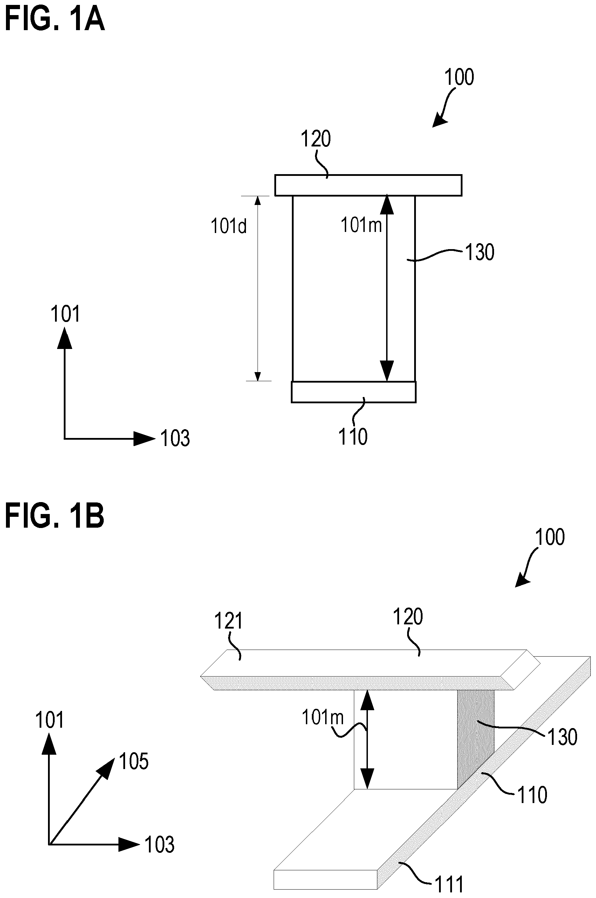

As illustrated in **FIG.1A****,** according to various aspects, the memristive structure 100 may include a first electrode 110 and a second electrode 120. The first electrode 110 and/or the second electrode 120 may include any suitable electrically conductive material, e.g., Al, Cu, Ti, AlCu, TiN, W, Ta, only as examples. The memristive structure 100 may further include a memristive material portion 130 (e.g., a memristive element). The memristive material portion 130 may be disposed between the first electrode 110 and the second electrode 120. Illustratively, the region in which the first electrode 110 and the second electrode 120 overlap one another may be (e.g., partially or completely) filled with memristive material. According to various aspects, the memristive material portion 130 may be in electrical contact and in direct physical contact with both the first electrode 110 and the second electrode 120. Therefore, a dimension 101m (e.g., a height or a thickness) of the memristive material portion 130 may be defined by a distance 101d from the first electrode 110 to the second electrode 120. The distance 101d from the first electrode 110 to the second electrode 120 may be understood as a shortest distance measure, for example, perpendicular to the planes in which the electrodes are formed. According to various aspects, the dimension (e.g., the height) of the memristive material portion 130 may be in a predefined range such that the memristive structure 100 has a substantially symmetric read characteristic and/or at least one curvature change in the read characteristic.

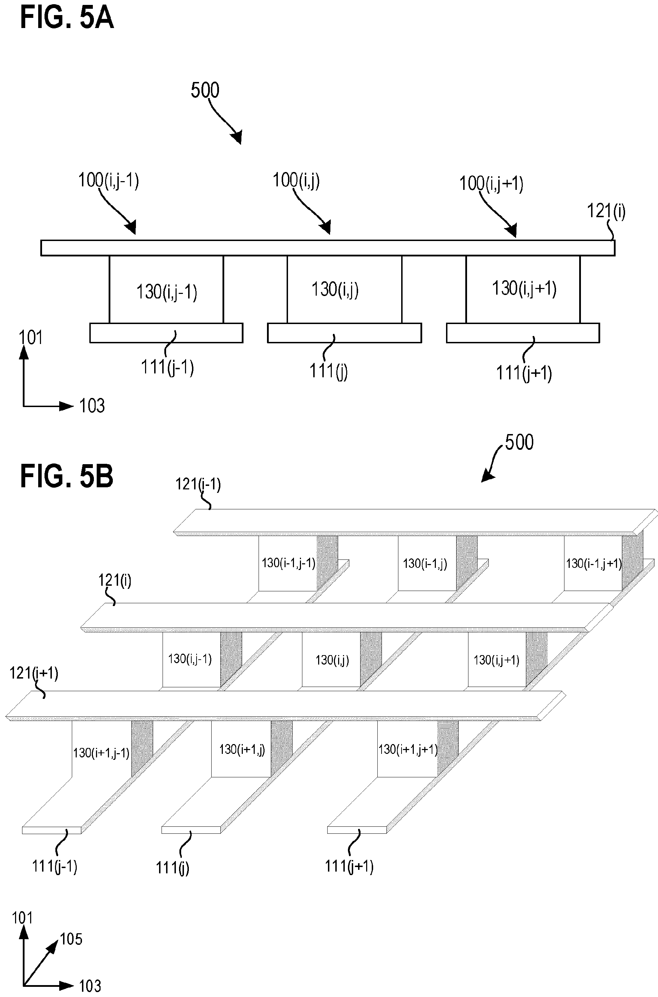

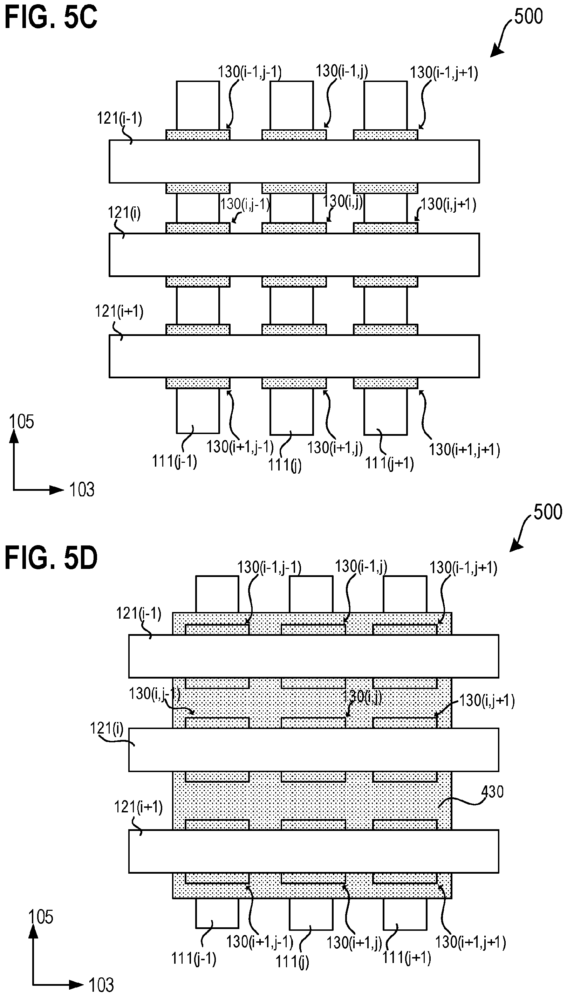

According to various aspects, the first electrode 110 and the second electrode 120 may be planar electrodes. The first electrode 110 and the second electrode 120 may be each a portion of a corresponding crossbar control line. As an example, a crossbar array may include a set of first control lines and a set of second control lines in a crossbar configuration, and the first electrode 110 may be a portion of a first control line 111 of the set of first control lines and the second electrode 120 may be a portion of a second control line 121 of the set of second control lines, as illustrated in **FIG.1B****,** see FIG.5B. In this example, the memristive material portion 130 may be in direct physical contact with both the first control line 111 and the second control line 121, and the memristive material portion 130 may be disposed between both the first control line 111 and the second control line 121. Accordingly, a memristive structure 100 can be provided in each of various cross-point regions of a crossbar array, see memristive crossbar array 500.

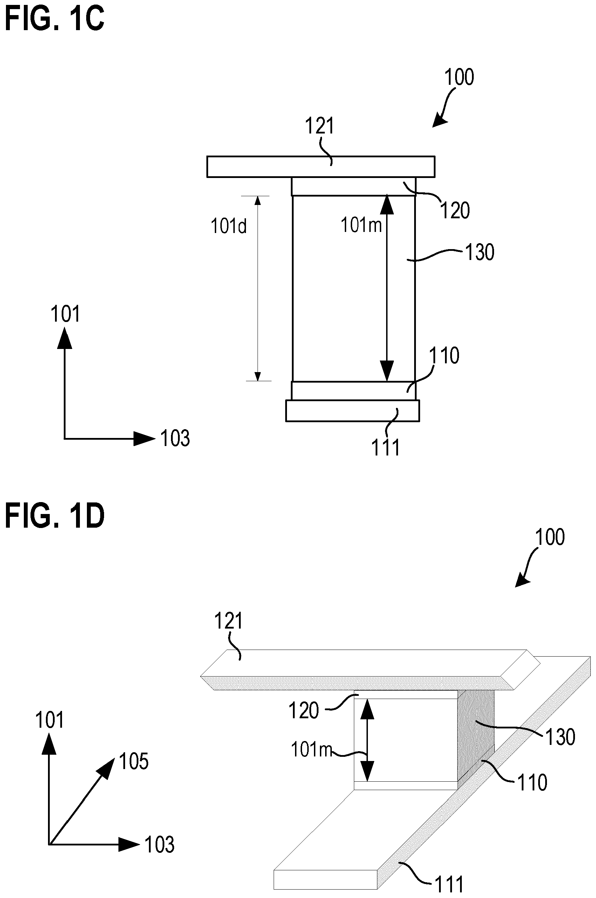

In other aspects, the first electrode 110 may be coupled to (e.g., electrically conductively connected to, e.g., in direct physical contact with) a corresponding first control line (e.g., a first control line of a crossbar array) and the second electrode 120 may be coupled to (e.g., electrically conductively connected to, e.g., in direct physical contact with) a corresponding second control line (e.g., a second control line of a crossbar array). As an example, a crossbar array may include a set of first control lines and a set of second control lines in a crossbar configuration, and the first electrode 110 may be coupled to (e.g., electrically conductively connected to, e.g., in direct physical contact with) a first control line 111 of the set of first control lines and the second electrode 120 may be coupled to (e.g., electrically conductively connected to, e.g., in direct physical contact with) a second control line 121 of the set of second control lines, as illustrated in FIG.1C and FIG.1D. In this example, the memristive material portion 130 may not be in direct physical contact with the first control line 111 and the second control line 121. But the first electrode 110 may be in direct physical contact with the first control line 111 and the second electrode 120 may be in direct physical contact with the second control line 121. The first electrode 110, the second electrode 120, and the memristive material portion 130 may be disposed between the first control line 111 and the second control line 121. Accordingly, a memristive structure 100 can be provided in each of various cross-point regions of a crossbar array.

According to various aspects, a crossbar array may define lateral (e.g., in plane) dimensions, e.g., along lateral directions 103, 105 shown in the figures. As an example, each control line (e.g., first control line 111) of a set of first control lines of the crossbar array may extend along a first lateral direction 105 and each control line (e.g., second control line 121) of a set of second control lines of the crossbar array may extend along a second lateral direction 103. The first lateral direction 105 may be perpendicular to the second lateral direction 103. A height direction 101 may be perpendicular to the first lateral direction 105 and/or the second lateral direction 103. The height direction 101 may be perpendicular to a planar surface of the first electrode 110 facing the memristive material portion 130 and/or perpendicular to a planar surface of the second electrode 120 facing the memristive material portion 130.

The dimension 101m (e.g., a height or a thickness) of the memristive material portion 130 may be defined along a direction parallel to the height direction 101. Accordingly, the distance 101d between the first electrode 110 and the second electrode 120 may be defined along a direction parallel to the height direction 101. The dimension 101m of the memristive material portion 130 may be greater than 150 nm. Accordingly, the distance 101d from the first electrode 110 to the second electrode 120 may be greater than 150 nm.

As explained above, the first control line 111 and the second control line 121 may be in a crossbar configuration to allow for an electrical addressing of the memristive structure 100 (i.e., the memristive material portion 130) via the first control line 111 and the second control line 121. An electrical addressing of the memristive structure 100 may be used to read information stored in the memristive structure 100 and/or to write (e.g., store) information into the memristive structure 100. In other words, an electrical addressing of the memristive structure 100 may be used to determine a state (e.g., a resistance state) in which the memristive structure 100 is residing and/or to set (e.g., keep or change) a state of the memristive structure 100.

In some aspects, the memristive material portion 130 may be patterned. Since the electric field between the first electrode 110 and the second electrode 120 may be substantially formed in the overlap region between the respective electrodes 110, 120, it may be sufficient to provide the memristive material only in the overlap region to form the memristive material portion 130, see, for example, FIGS.1A to 1D. In this case, according to various aspects, the memristive material portion 130 has an aspect ratio of greater than 1, e.g., greater than 2, greater than 5, greater than 10. The aspect ratio may be defined by the height (e.g., the dimension along the height direction 101) of the memristive material portion 130 divided by a width (e.g., along one of the lateral directions 103, 105) of the memristive material portion 130. A sufficiently great height of the memristive material portion 130 and therefore a comparatively high aspect ratio may be essential to provide a memristive material portion 130 with ideal analog read properties. However, since due to manufacturing aspects, it may be difficult to form such a memristive material portion 130 with a comparatively high aspect ratio, the memristive material portion 130 may be provided by a non-patterned layer of a memristive material and/or the memristive material portion 130 may have a greater lateral extension than the overlap region between the electrodes 110, 120, as explained in further detail below. However, a sufficiently great height of the memristive material portion 130 may be realized in any cases to achieve ideal analog read properties.

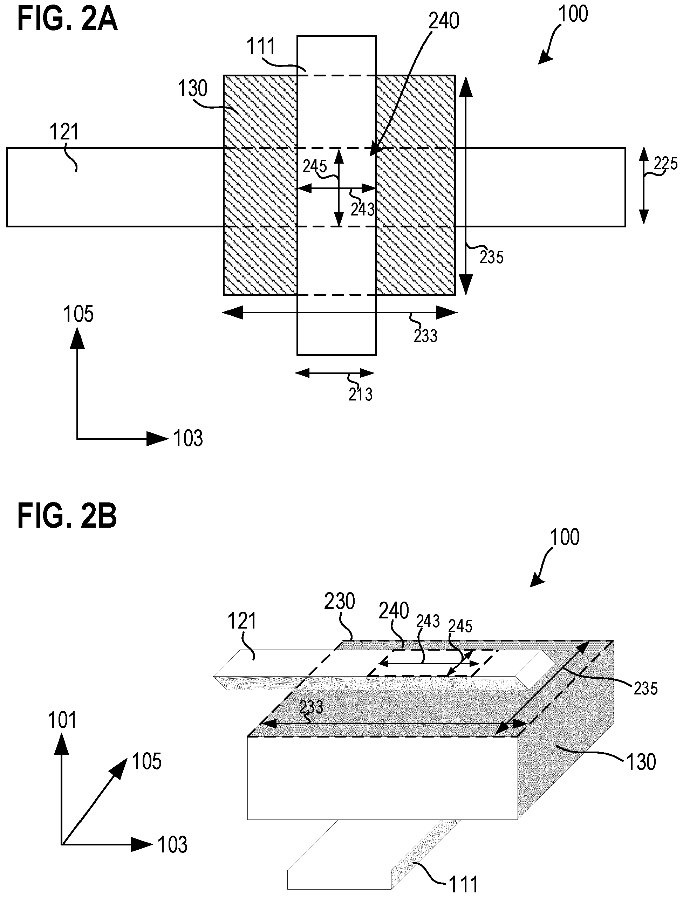

**FIG.2A** and **FIG.2B** show various aspects of a memristive structure 100 in a schematic view. An overlap of the first control line 111 and the second control line 121 with one another may define a cross-point area 240 and a cross-point region. The cross-point area 240 may be a vertical projection of the second electrode 120 onto the first electrode 110 or vice versa. In some aspects, the cross-point area 240 may be referred to as an overlap area 240. The cross-point area 240 may be defined within a plane perpendicular to the height direction 101 (i.e. parallel to the lateral directions 103, 105). The absolute value (distance 243 multiplied with distance 245) of the cross-point area 240 may be defined by a width 213 (along the second lateral direction 103) of the first control line 111 and a width 225 (along the first lateral direction 105) of the second control line 121. The cross-point area 240 may define the portion of the first control line 111 that provides the first electrode 110 of the memristive structure 100 and the portion of the second control line 121 that provides the second electrode 120 of the memristive structure 100. The region between the portion of the first control line 111 that provides the first electrode 110 of the memristive structure 100 and the portion of the second control line 121 that provides the second electrode 120 of the memristive structure 100 may be considered as the cross-point region or overlap region.

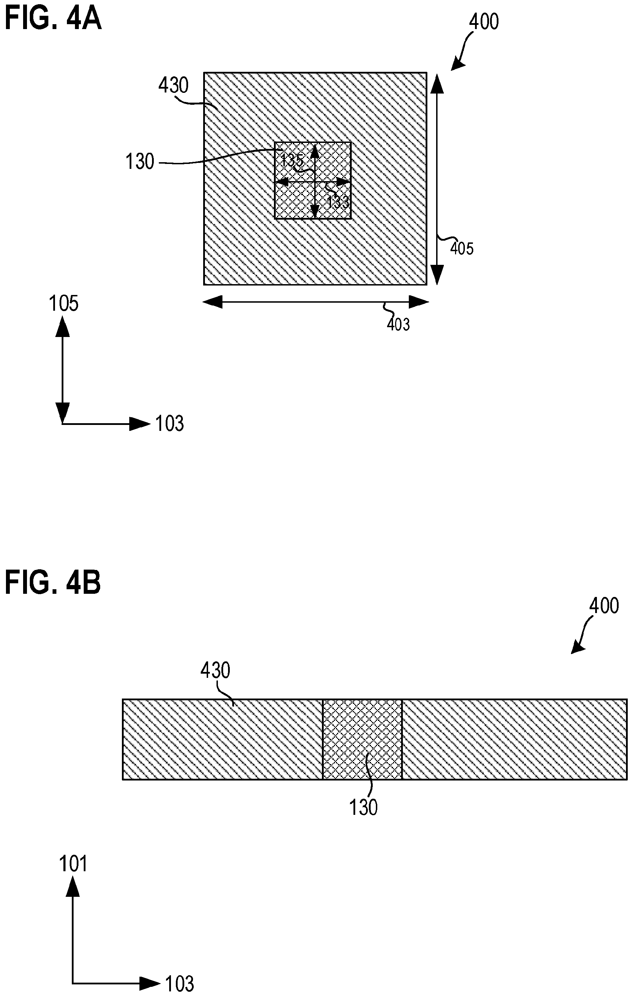

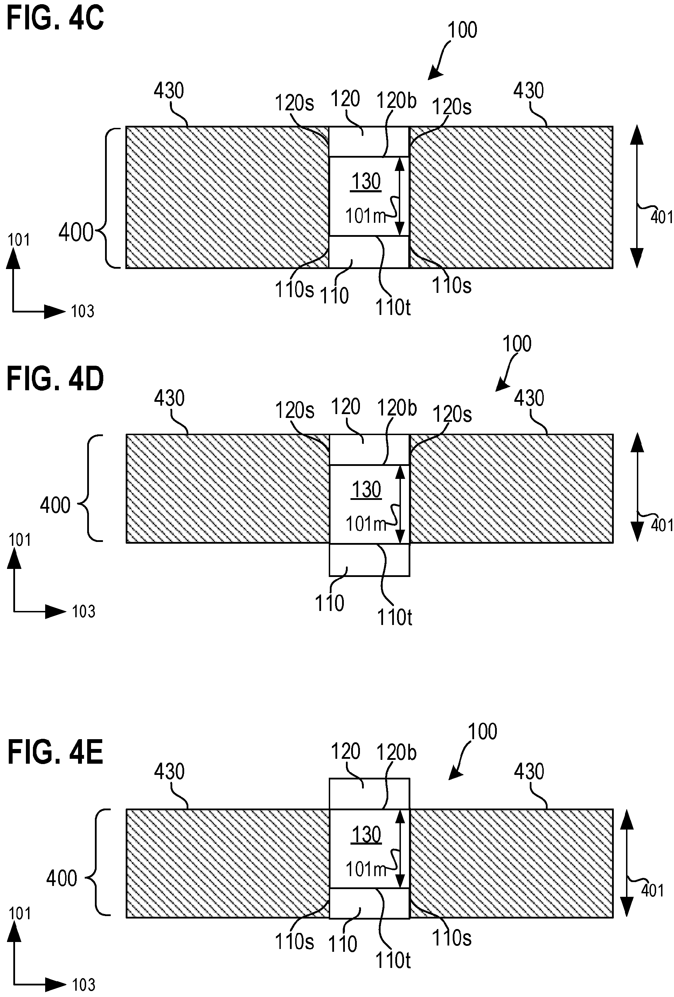

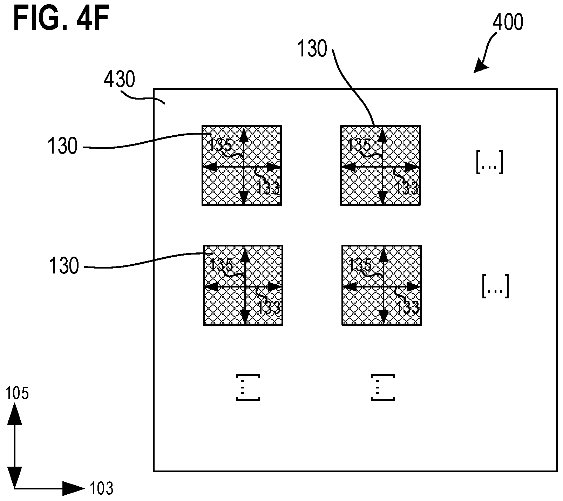

According to various aspects, a dimension of the memristive material portion 130 parallel to the cross-point area 240 may be greater than a dimension of the cross-point area 240. As illustrated, for example, in FIGS.2A and 2B, a first lateral dimension 235 of the memristive material portion 130 along the first lateral direction 105 may be greater than a first lateral dimension 245 of the cross-point area 240 along the first lateral direction 105. As illustrated, for example, in FIGS.2A and 2B, a second lateral dimension 233 of the memristive material portion 130 along the second lateral direction 103 may be greater than a second lateral dimension 243 of the cross-point area 240 along the second lateral direction 103. Accordingly, the surface area 230 of the memristive material portion 130 may be greater than the cross-point area 240. A memristive material portion 130 that has a greater lateral extension than the control lines or the electrodes (e.g., as described above) may allow for an easier fabrication of a memristive crossbar array, since processing requirements for patterning such structures may decrease with increasing lateral dimensions. In some aspects, a plurality of (or even all) memristive material portions of a memristive crossbar array may be provided by a laterally non-patterned memristive material layer, see FIG.4F and FIG.5D.

In the case that a lateral dimension of the memristive material portion 130 is greater than a lateral dimension of the cross-point area 240, the memristive material of the memristive material portion 130 in the cross-point region may define an active memristive region being laterally surrounded by a passive memristive region. The memristive material of the memristive material portion 130 outside the cross-point region (e.g., in the passive memristive region) may not be address by the first control line 111 and the second electrode control line 121. The memristive material of the memristive material portion 130 outside the cross-point region (e.g., in the passive memristive region) may be in direct contact with neither the portion of the first control line 111 that provides the first electrode 110 of the memristive structure 100 nor the portion of the second control line 121 that provides the second electrode 120 of the memristive structure 100. The memristive material of the memristive material portion 130 outside the cross-point region (e.g., in the passive memristive region) may not be address by the any control line of a memristive array.

As illustrated in FIGS.2A and 2B, the respective control lines themselves may provide the first electrode 110 and the second electrode 120 of the memristive structure 100. However, in other configurations, the first electrode 110 and the second electrode 120 may be coupled to the corresponding control lines, and therefore, the corresponding control lines may not be in direct physical contact with the memristive material portion 130 (e.g., the corresponding control lines may not be in direct physical contact with the memristive material in the active memristive region).

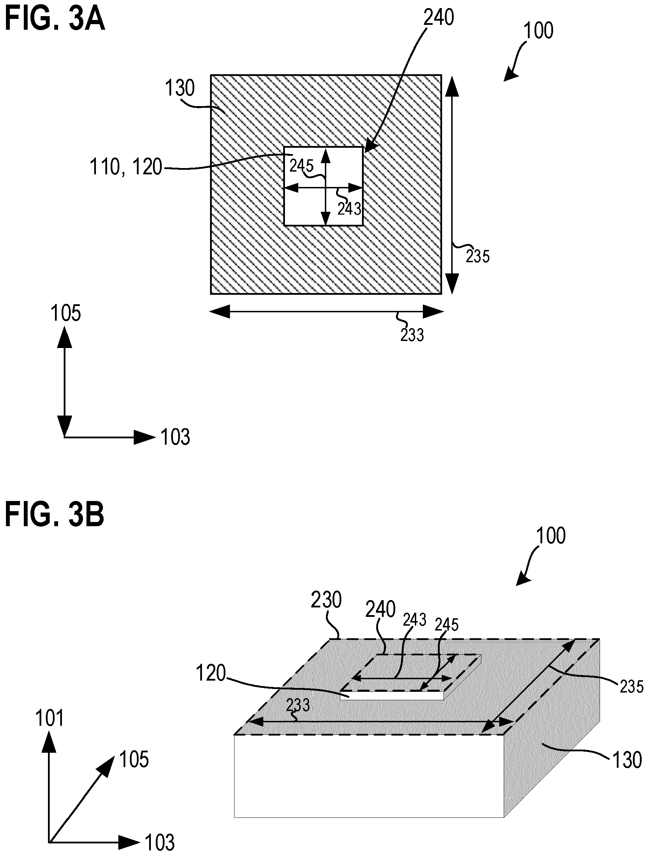

**FIG.3A** to **FIG.3D** show various aspects of a memristive structure 100 in a schematic view. An overlap of the first electrode 110 and the second electrode 120 with one another may define the cross-point area 240 and the cross-point region similar to the aspects described above with reference to FIGS.2A and 2B. The cross-point area 240 may be, in this case, a vertical projection of the second electrode 120 onto the first electrode 110 or vice versa. The absolute value (distance 243 multiplied with distance 245) of the cross-point area 240 may be defined by an electrode area (e.g., along the lateral directions 103, 105) of the respective electrodes 110, 120.

According to various aspects, a contact distance (e.g., distance 243 and/or distance 245 illustrated in FIGS.2A to 3B), defined between the first electrode 110 and the memristive material portion 130 along a direction (e.g., along direction 103 and/or along direction 105), is less than a width (233, 235) of the memristive material portion 130 along the same direction. In a similar way, a contact distance, defined between the second electrode 120 and the memristive material portion 130 along a direction (e.g., along direction 103 and/or along direction 105), is less than a width (233, 235) of the memristive material portion 130 along the same direction.

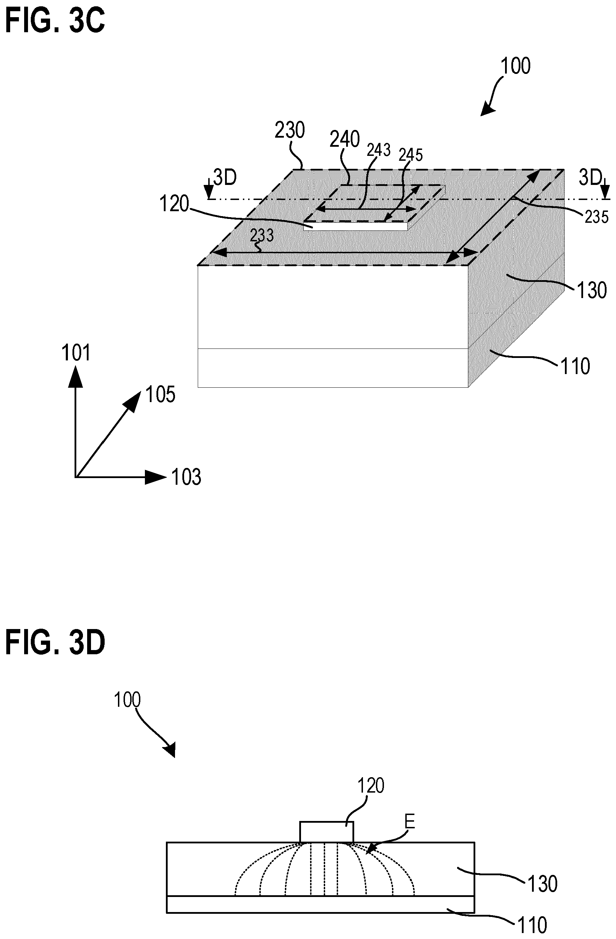

In some aspects, the cross-point area 240 may be substantially defined by an area of the first electrode 110 or by an area of the second electrode 120. For example, the area of the first electrode 110 may be much greater than the corresponding (e.g., overlapping) area of the second electrode 120, as illustrated in FIG.3C. In FIG.3D a cross sectional view of the memristive structure 100 of FIG.3C along the line 3D-3D is illustrated. When an electrical field E is formed within the memristive material portion 130, as illustrated in FIG.3D (see dotted lines), a lateral dimension of the electrical field may be defined by the area of the smaller electrode, which is, for example, in this case the second electrode 120. Thereby, an edge portion of the electrical field E, which extends over the vertical projection of the second electrode 120 onto the first electrode, may be defined as well. Thereby an influence of the electrical field E to other neighboring memristive material portions (not illustrated) may be diminished. In some aspects, the size and shape of an electric field E caused by the electrodes 110, 120 of the memristive structure 100 may be adapted to allow for enhanced electric properties of the memristive structure 100 by adapting the size, position, and/or shape of the electrodes 110, 120.

**FIG.4A** to **FIG.4F** show various aspects of a memristive material layer 400 that provides one or more memristive material portions 130 of one or more memristive structures 100. In some aspects, one or more portions of the memristive material layer 400 may be one or more memristive material portions 130 of one or more memristive structures 100 include in a memristive array, e.g., included in the memristive crossbar array 500. The memristive material layer 400 may include at least one other portion 430 neighboring (e.g., laterally surrounding) the one or more memristive material portions 130. The memristive material portion 130 may be disposed in the cross-point region between the first electrode 110 and the second electrode 120. The at least one other portion 430 may cover one or more or all regions between the cross-point regions of a memristive crossbar array.

According to various aspects, the at least one other portion 430 of the memristive material layer 400 may have, for example, a thickness that is greater than the distance 101d from the first electrode (110) to the second electrode (120). The at least one other portion 430 of the memristive material layer 400 may have, for example, a thickness that is greater than the dimension 101m of the one or more memristive material portions 130.

According to various aspects, the memristive material layer 400 may cover a surface 110t (e.g., a top surface) of the first electrode 110 facing the second electrode 120 and a surface 120b (e.g., a bottom surface) of the second electrode 120 facing the first electrode 110. In some aspects, the memristive material layer 400 may cover additionally at least one further surface 110s (e.g., a lateral surface, e.g., a sidewall) of the first electrode 110 and/or at least one further surface 110s (e.g., a lateral surface, e.g., a sidewall) of the second electrode 120, see, for example, FIGS.4C to 4E.

According to the invention, the memristive material layer 400 comprises bismuth ferrite as basic memristive material. In some aspects, to provide the memristive material portion 130, the basic memristive material may be doped by a dopant with a first dopant concentration. The dopant may include crystallographic vacancies (e.g., oxygen vacancies) introduced into the basic material. The dopant may include crystallographic traps (e.g., titanium ions) to trap the crystallographic vacancies (e.g., the oxygen vacancies). In some aspects, the memristive material portion 130 may include the basic material doped with both vacancies and vacancy traps. In some aspects, to provide the at least one other portion 430 of the memory material layer 400, the basic memristive material 400 may be un-doped with respect to the dopant or may be doped with a second dopant concentration different from (e.g., less than, e.g., at least one order of magnitude lower than) the first dopant concentration.

**FIG.5A** to **FIG.5D** show various aspects of a memristive array, e.g., a memristive crossbar array 500 in a schematic view. The memristive crossbar array 500 may include, without loss of generality, M times N memristive structures 100 (in a so called MxN-array) formed by a number of M first control lines 111(j) and a number of N second control lines 121(i) with j ranging from 1 to M and i ranging from 1 to N. In each of the cross-point regions of a corresponding pair of first control lines (j) and second control lines (i) a memristive material portion 130(i,j) is formed to provide the memristive structure 100(i,j). The memristive crossbar array 500 may include memristive structures 100(i,j), wherein each of the memristive structures 100(i,j) may be configured as described herein with reference to memristive structure 100.

In some aspects, the memristive array may include memristive material portions 130(i,j) that are substantially defined by electrodes. Therefore, the electrodes may be directly formed on the memristive material layer 400, e.g., in a matrix structure. For example, one or more first electrodes 110 formed on one side of the memristive material layer 400 and one or more second electrodes 120 formed on another side of the memristive material layer 400 may overlap each other in corresponding projections as described herein (e.g. with reference to Figures 3A to 3D) thereby forming corresponding memristive material portions 130(i,j) within the memristive material layer 400 that may be also referred to as overlap portion in which the corresponding electrodes overlap one another in a vertical projection. In some aspects, multiple control lines or a metal plate may be formed on one side of the memristive material layer 400 and multiple electrodes may be formed on the other side of the memristive material layer 400 to operate (e.g., to individually address) each of the memristive material portions 130(i,j).

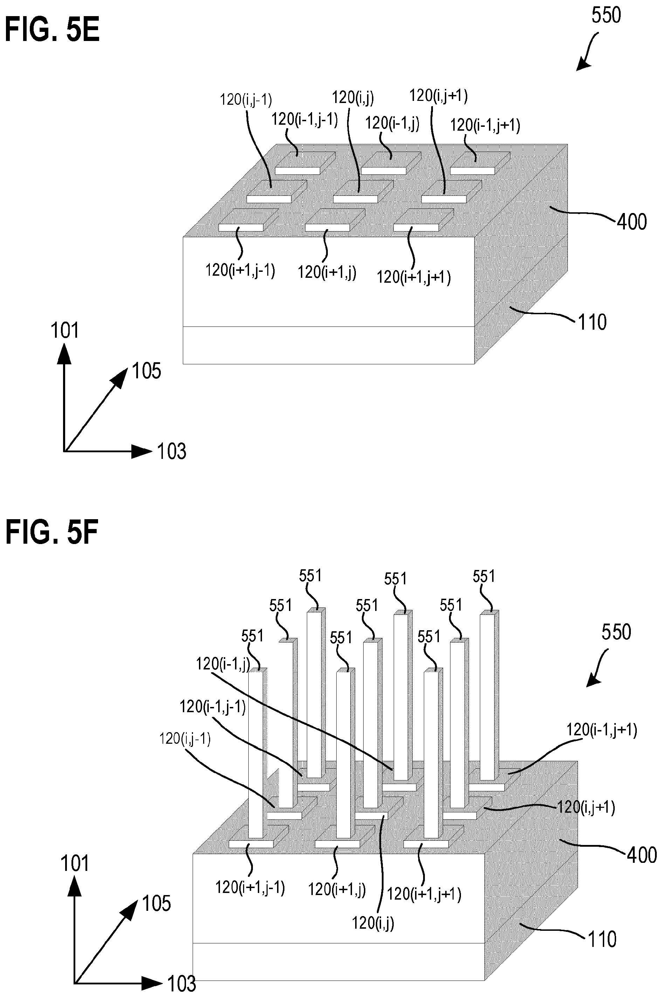

For example, FIG.5E shows a memristive array 550 including a plurality of second electrodes 120, arranged in a matrix structure, that are arranged on one side of the memristive material layer 400. Furthermore, a first electrode 110, that may be formed as a layer (also referred to as plate or plate-line), is arranged on another side of the memristive material layer 400. By forming the electrode on one side as a layer an electric resistance of the memristive array 550 may be reduced, which may be substantially limited by the thinnest connections within the memristive array 550. However, in some aspects instead of one first electrode 110 implemented as a layer, multiple first electrodes 110 may be used to implement the memristive material portions 130(i,j).

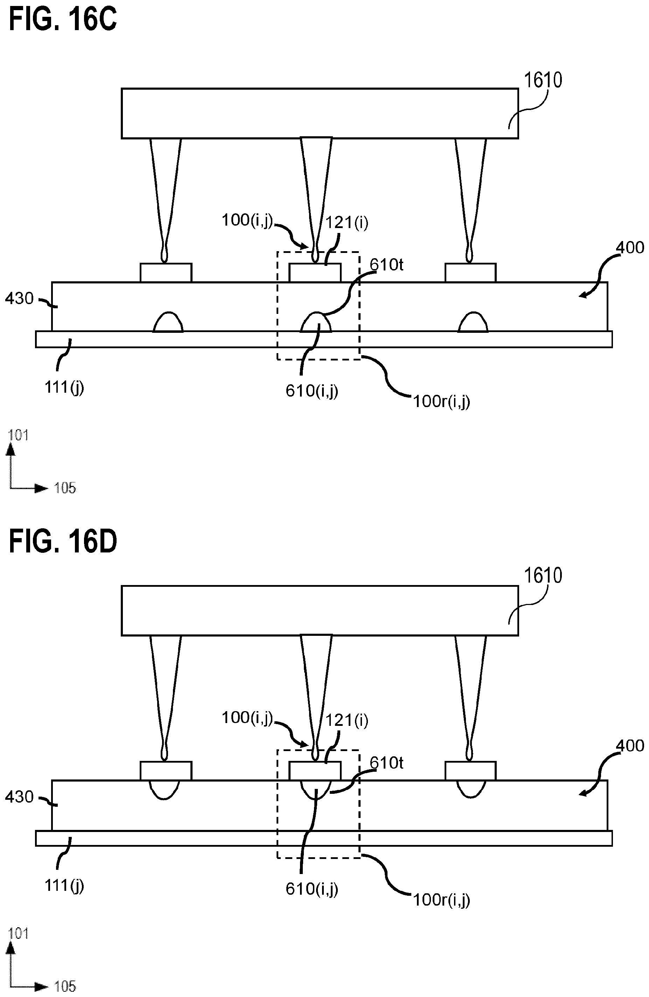

According to various aspects, the multiple electrodes, e.g., the multiple first and/or second electrodes, may be directly connected, i.e., without any rerouting patterns or metallization layers, to an outer connection terminal, such as a needle connection board, solder bumps, a ball grid array, only as examples. For example, a connection between toe the first and/or second electrodes to a needle connection board 1610 is exemplarily shown in Figures 16C to 16G. This may allow for directly addressing each memristive material portion 130(i,j) via its corresponding electrodes and thereby allow for a reduction of fabrication costs, since additional metallization layers are not needed to provide an interconnection structure. FIG.5F illustrates a memristive array 550 including multiple needles 551, wherein each of the multiple needles 551 is connected to a corresponding second electrode, thereby allowing for a direct addressing of the respective corresponding memristive material portions 130(i,j).

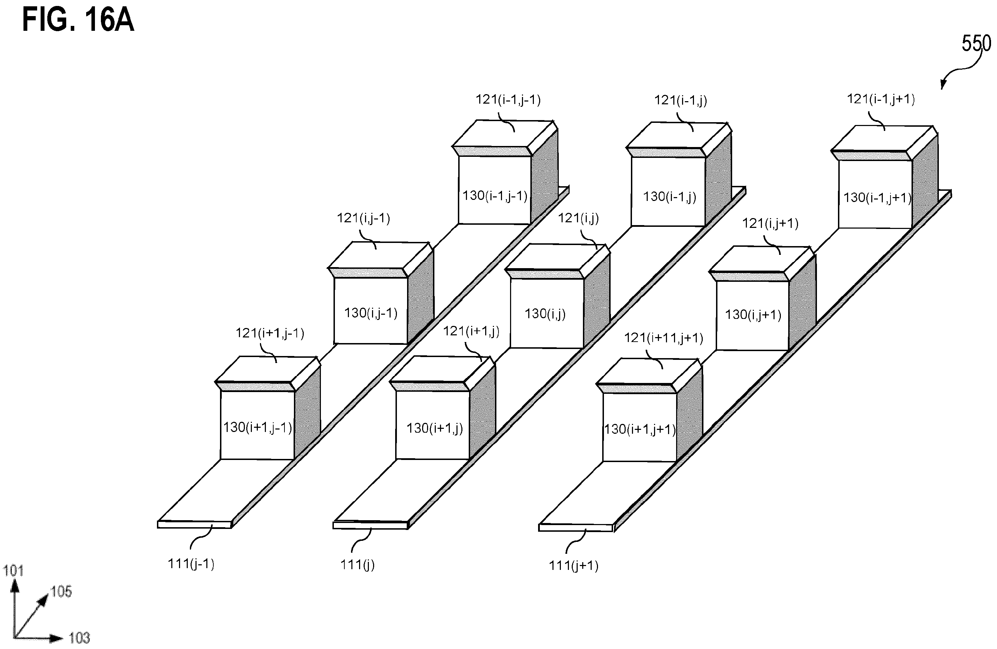

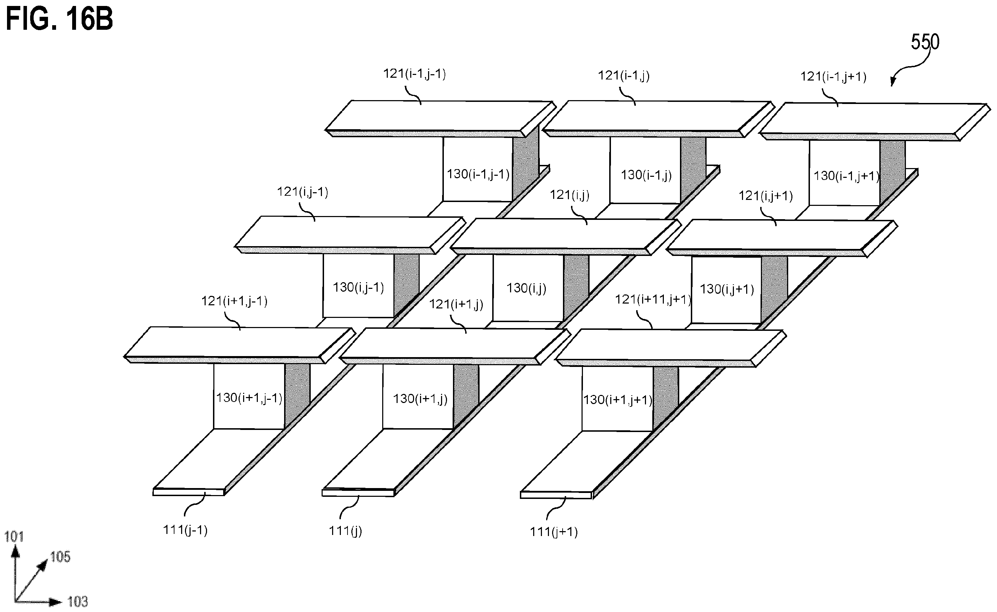

In some aspects, the first control line 111 and/or the second control line 121 may be an interrupted first control line 111 or an interrupted second control line 121 including multiple control line segments 121(i,j), 111(i.j), respectively. For example, the multiple control line segments of one control line, may be electrically insulated from each other. For example, two neighboring segments of the multiple control line segments of one control line, may be spaced apart from each other. For example, FIG.16A and FIG 16B show each a memristive array 550 including multiple interrupted second lines 121(j) including multiple control line segments 121(i,j). For example, the multiple control line segments 121(i,j) may act as a connection terminal (that may be similar to an electrode) to the corresponding memristive material portions 130(i,j). For example, the first control lines 111 may not be interrupted control lines. Thereby, an individual addressing of a respective memristive material portion 130(i,j) may be implemented by addressing its corresponding first control line 111(i) and its corresponding control line segments 121(i,j) of the corresponding control line 121(j).

In some aspects, the corresponding control line segment portions may overlap the corresponding memristive material portions 130(i,j), see FIG.16B as an example. This may allow for implementing a greater landing area on which contact may placed on, such as a needle of a needle of a needle connection board 1610.

In some embodiments, in which the second control line 121 may be an interrupted second control line 121, the cross-point regions 100r(i,j) may be referred to as overlap regions, which are each defined by the projection of the corresponding second control line segment 121(i,j) to the corresponding first control line 111, the corresponding first control line segment 111(i,j) or to the corresponding area on a plate (e.g. a plate line) implementing the first control line. It should be noted, that in some embodiments, the first control line 121 may be an interrupted first control line 111, mutatis mutandis.

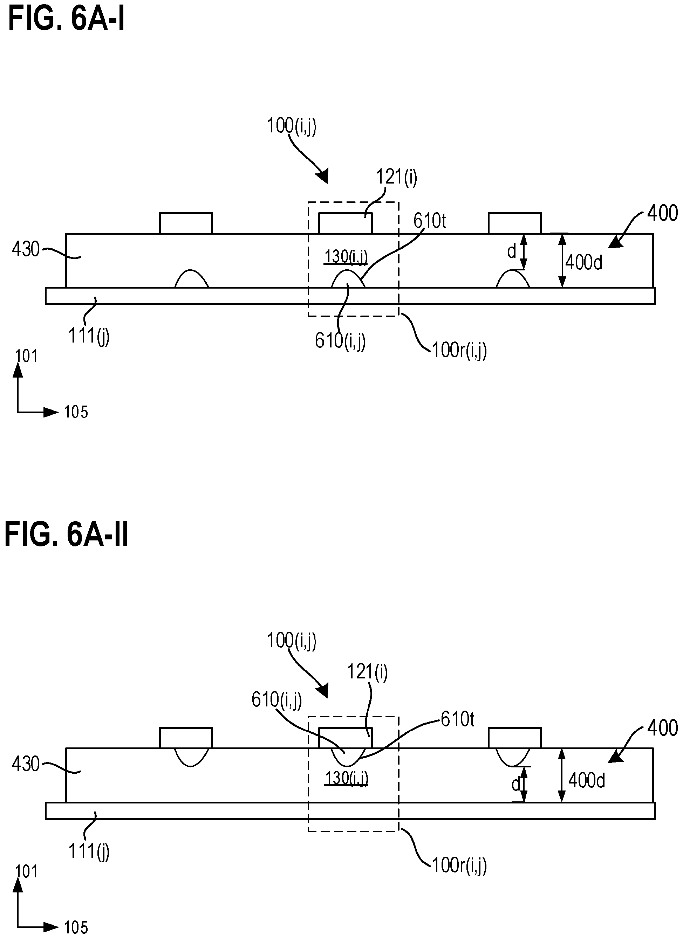

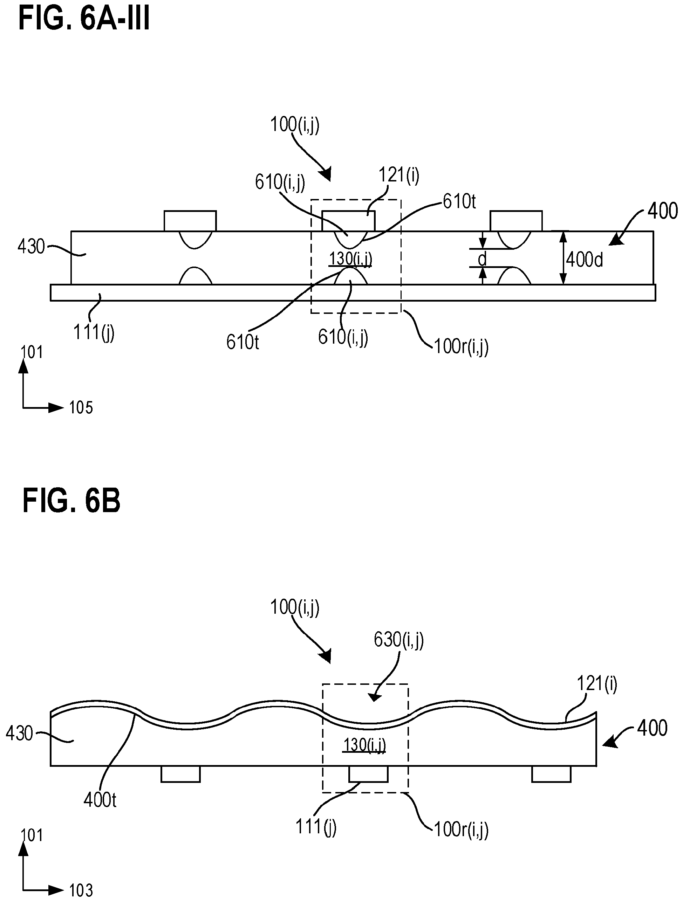

**FIG.6A** more memristive structures 100 in a schematic view. In some aspects, the first control line 111 and/or the first electrode 110 may be configured (e.g., formed, e.g., patterned) to channel an electric filed applicable via the first control line 111 and/or the first electrode 110 in the cross-point regions 100r(i,j). In other aspects, the second control line 121 and/or the second electrode 120 may be configured (e.g., formed, e.g., patterned) to channel an electric filed applicable via the second control line 121 and/or the second electrode 120 in the cross-point regions 100r(i,j). In still other aspects, the memristive material portion 130 and/or a material portion 430 neighboring the memristive material portion 130 may be configured (e.g., formed, e.g., patterned, doped) to channel an electric filed applicable via the first control line 111 and/or the first electrode 110 and via the second control line 121 and/or the second electrode 120 in the cross-point regions 100r(i,j).

According to various aspects, as illustrated in Figures 6A-I to 6A-III, the first control line 111 and/or the first electrode 110 may be patterned and/or formed such that a portion 610(i,j) of the first control line 111 and/or the first electrode 110 protrudes (e.g., in the height direction) into the memristive material portion 130 in the cross-point regions 100r(i,j). This may cause a higher electric field density in the cross-point regions 100r(i,j) than outside the cross-point regions 100r(i,j). The portion 610(i,j) may have an angled or curved surface 610t facing the second electrode 120 and/or the second control line 121(i). The protruding portion 610(i,j) may reduce an effective distance d from the first electrode 110 to the second electrode 120 to a value that is smaller than a thickness 400d (e.g., 401) of the memristive material layer 400 that provides the memristive material portions 130(i,j). In some aspects both, the first control line 111 and the first electrode 110, may be patterned and/or formed such that a portion 610(i,j) of the first control line 111 and the first electrode 110 protrude (e.g., in the height direction) into the memristive material portion 130 in the cross-point regions 100r(i,j), as depicted in FIG.6A-III, the effective distance d from the first electrode 110 to the second electrode 120 may be even more reduced. By decreasing the effective distance d from the first electrode 110 to the second electrode 120, the electrical field in the cross-point regions 100r(i,j) may be confined and edge effects may be diminished.

According to various aspects, as illustrated in FIG.16C and 16D the first control line 111 and/or the second control line 121 may be an interrupted first control line 111 or an interrupted second control line 121 including multiple control line segments 121(i,j), 111(i.j), respectively. According to various aspects, as illustrated in FIG.16C, the multiple control line segments 121(i,j) may be contacted individually using a needle connection board 1610. This may allow to contact the memristive material portion 130 in the cross-point regions 100r(i,j) via the needle connection board 1610.

According to various aspects, as illustrated in FIG.6B, a surface 400t (e.g., a top surface, a bottom surface) of the memristive material layer 400 may be patterned and/or formed such that the memristive material layer 400 has a smaller thickness (e.g., a smaller dimension along direction 101) in the cross-point regions 100r(i,j) than outside the cross-point regions 100r(i,j). The surface 400t of the memristive material layer 400 may have a substantially periodic pattern correlated with the distance (e.g., in lateral direction along direction 103) between neighboring first control lines 111(j) and/or first electrodes 110. The respective second control lines 121(i) may be deposited directly on the patterned (e.g., height patterned) memristive material layer 400.

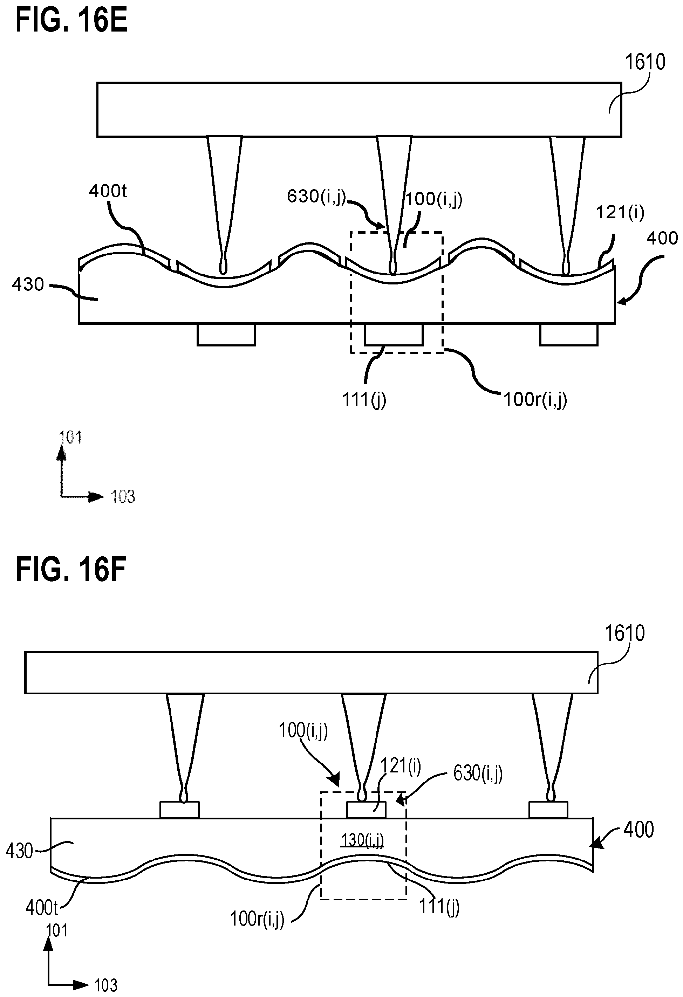

According to various aspects, the second control lines 121(i) may be implemented as interrupted second control lines 121(i) that are formed on the patterned side of the memristive material layer 400, as exemplarily shown in FIG.16E. Furthermore, the second control lines 121(i), e.g., the segments of the second control lines 121(i) may be contacted using a needle connection board 1610.

In another example, that is illustrated in FIG.16F, the surface 400t, which is patterned or formed such that the memristive material layer 400 has a smaller thickness in the cross-point regions 100r(i,j) than outside the cross-point regions 100r(i,j), may be a bottom surface. For example, the first control lines 111 may be arranged on the surface 400t. Another surface of the memristive material layer 400, opposite to the surface 400t, may not be patterned, e.g., may be substantially flat. On the other surface, the second control lines 121(j) may be arranged on. For example, the second control lines 121(j) may be interrupted second control lines each including multiple second control line segments. For example, the second control lines 121(i), e.g., the segments of the second control lines 121(i), may be contacted using a needle connection board 1610.

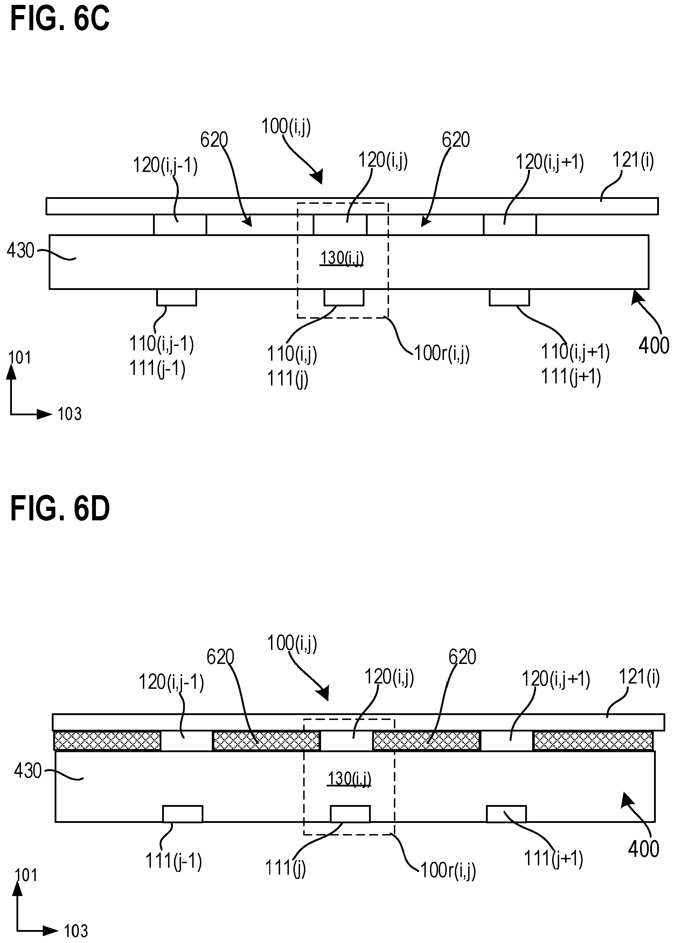

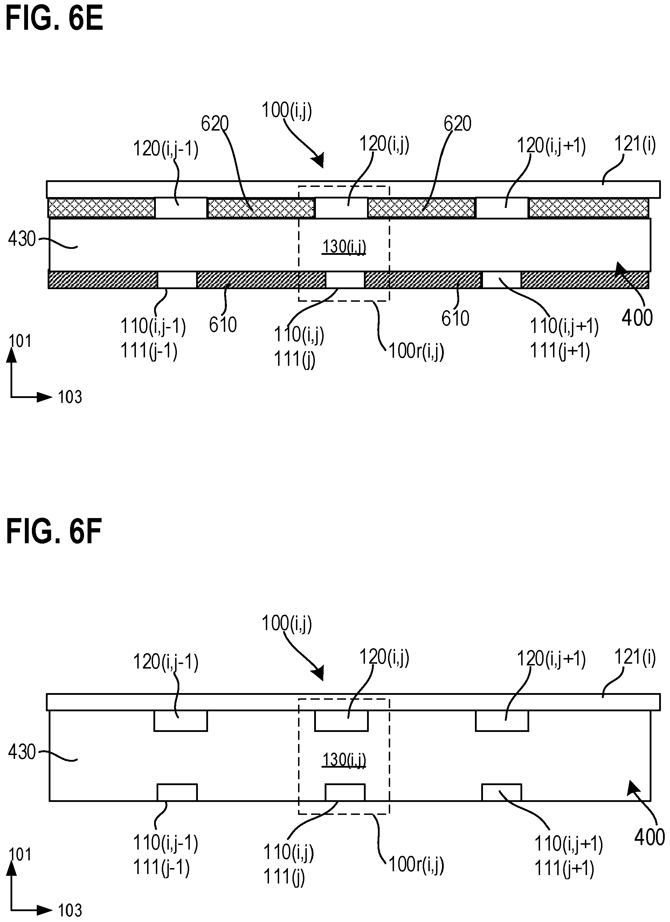

According to various aspects, as illustrated in FIG.6C, FIG.6D, and FIG.6E, the respective second control lines 121(i) of the memristive crossbar array 500 may be formed spaced apart from the memristive material layer 400. The second electrodes 120(i,j) may be in direct physical contact with the memristive material layer 400 and the second control lines 121(i) may be electrically conductively connected (e.g., may be in direct physical contact) with corresponding second electrodes 120(i,j=1 to N). A space 620 between neighboring second electrodes 120(i,j) (and between the second control lines 121(i) and the memristive material layer 400) may be free of memristive material (e.g., free of the basic memristive material included in the memristive material layer 400), free of any material (e.g., an airgap is formed), or filled with a dielectric material (e.g., filled with an oxide material that has no memristive properties).

According to various aspects, as illustrated in FIG.6C and FIG.6E, a space 610 between neighboring first electrodes 110(i,j) or first control lines 111(j) may be free of memristive material (e.g., free of the basic memristive material included in the memristive material layer 400), free of any material (e.g., an airgap is formed), or filled with a dielectric material (e.g., filled with an oxide material that has no memristive properties).

According to various aspects the first electrodes 110(i,j) and/or first control lines 111(j) may be formed within the memristive material layer 400. This is for example, illustrated in FIG.6F. This may allow for reducing the effective distance d from the first electrode 110 to the second electrode 120, compared to a value of the thickness 400d of the memristive material layer 400.

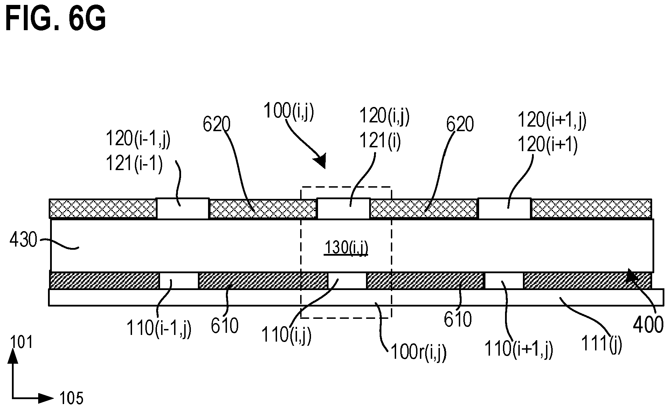

According to various aspects, as illustrated in FIG.6G, a space 620 between neighboring second electrodes 120(i,j) or second control lines 121(j) may be free of memristive material (e.g., free of the basic memristive material included in the memristive material layer 400), free of any material (e.g., an airgap is formed), or filled with a dielectric material (e.g., filled with an oxide material that has no memristive properties).

According to various aspects, as illustrated in FIG.6G, the respective first control lines 111(j) of the memristive crossbar array 500 may be formed spaced apart from the memristive material layer 400. The first electrodes 110(i,j) may be in direct physical contact with the memristive material layer 400 and the first control lines 111(j) may be electrically conductively connected (e.g., may be in direct physical contact) with corresponding first electrodes 110(i=1 to M,j). A space 610 between neighboring first electrodes 110(i,j) (and between the first control lines 111(j) and the memristive material layer 400) may be free of memristive material (e.g., free of the basic memristive material included in the memristive material layer 400), free of any material (e.g., an airgap is formed), or filled with a dielectric material (e.g., filled with an oxide material that has no memristive properties).

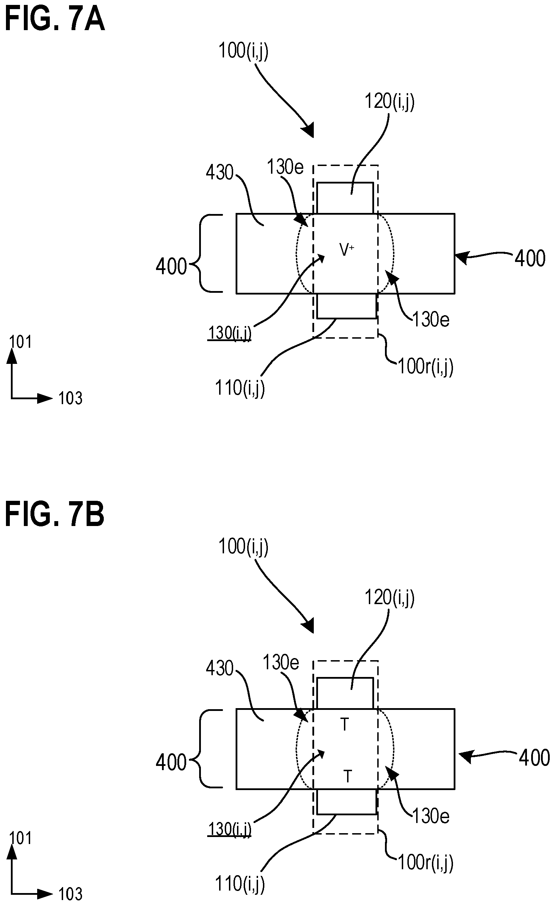

**FIG.7A** and **FIG.7B** show various aspects of a memristive structure 100, e.g., included in a memristive crossbar array, in a schematic view. In some aspects, at least a portion of the memristive material layer 400 may be modified, e.g., to cause a vacancy doping V⁺ or V⁻ in the cross-point regions 100r(i,j), as illustrated in FIG.7A. In some aspects, the memristive material portion 130 may include an n-type memristive material that has a positive vacancy doping V⁺, e.g. anion vacancy. In other aspects, the memristive material portion 130 may include a p-type memristive material that has a negative vacancy doping V⁻, e.g. cation vacancy. In the case that the memristive material that form the memristive material portion 130 is an oxide, e.g., BiFe_{y}Oₓ, the vacancy doping V⁺ may be cause by oxygen vacancies V_{O}⁺. In some aspects, at least a portion of the memristive material layer 400 may be modified, e.g., to cause traps T in the cross-point regions 100r(i,j), as illustrated in FIG.7B. Accordingly, the memristive material portion 130 may include traps T. As an example, the traps T may be caused by introduction of metal iones (e.g., titanium ions) into the memristive material.

A function of the memristive material portion 130 may be understood in terms of movable vacancies V⁺ that can be locally trapped in regions of the memristive material portion 130. The traps T may be introduced adjacent to the first electrode 110 and second electrode 120 and the movable vacancies V⁺ may selectively move either into the region adjacent to the first electrode 110 or into the region adjacent to the second electrode 120 and trapped there accordingly in an electric field. This may allow for generating selectively a Schottky-type diode either with maximum barrier height at the first electrode 110 or with maximum barrier height at the second electrode 120 such that the memristive structure 100 exhibit a nonlinear switching behavior and is self-rectifying.

According to various aspects an electrical field may be formed between the first electrode 110 and the second electrode 120. The formed electrical field may include edge portions 130e that may be formed within the memristive material layer 400 and that may affect an electrical characteristic of the memristive structure 100, e.g., a switching characteristic. However, the Traps T and the vacancy doping V⁺ or V⁻ may decrease the formation of such edge portions 130e and/or may inhibit the influence of such edge portions 130e to the electrical characteristic of the memristive structure 100. In some aspects, the Traps T and the vacancy doping V⁺ or V⁻ may support a switching characteristic of the memristive material portion 130 even though edge portions 130e are present.

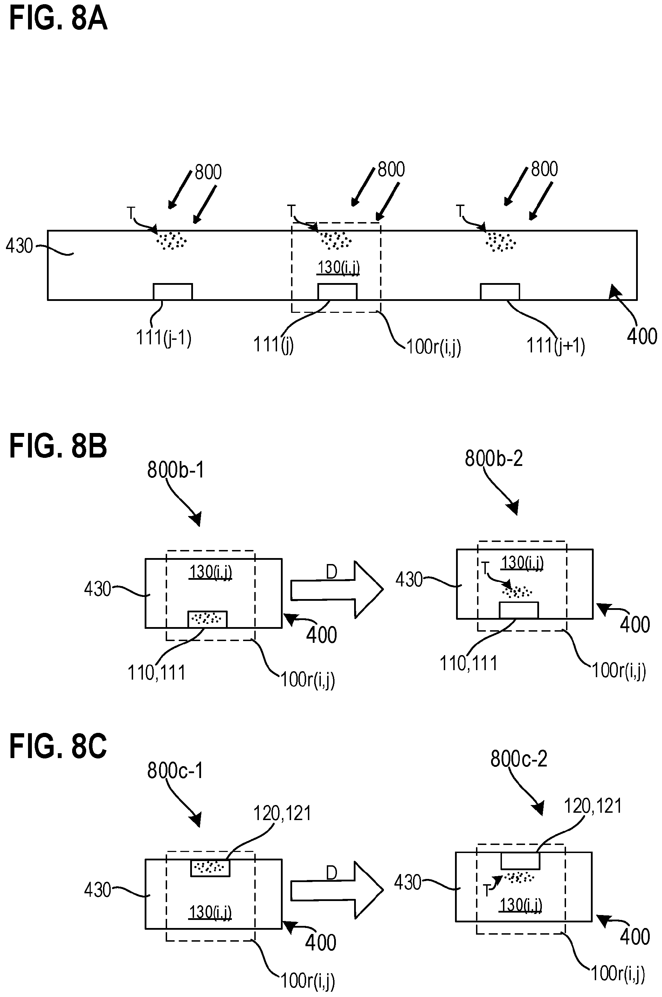

**FIG.8A** to **FIG.8C** show various aspects of modifying a memristive material in the cross-point regions 100r(i,j) to form a memristive crossbar array. In some aspects, at least a portion of the memristive material layer 400 or a portion of a memristive material in the cross-point regions 100r(i,j) may be modified to cause traps T in the cross-point regions 100r(i,j).

As illustrated in FIG.8A, the traps T may be caused by an implantation 800 of metal ions, e.g., titanium ions. This ion implantation 800 may be carried out prior to forming the second electrodes and/or the second control lines 121. The ion implantation 800 may be carried out via a mask (e.g., a patterned mask layer) to implant the ions only in the cross-point regions 100r(i,j). Illustratively, the active memristive material portion 130 may be defined by the implanted ions. Therefore, a patterning of the memristive material layer 400 may not be necessary. In a similar way, the vacancies V⁺ may be caused locally, e.g., only in the cross-point regions 100r(i,j) to thereby define active memristive material portions 130. It may be understood that, in some aspects, a memristive material layer 400 is formed that includes a memristive material, but, that portions of the memristive material layer 400 are modified to provide active memristive material portions 130 and non-active memristive material portions 430, wherein active memristive material portions 130 provide memristive functions as described herein and wherein non-active memristive material portions 430 are not utilized in terms of memristive functions. The non-active memristive material portions 430 may electrically separate the active memristive material portions 130 from one another and may allow for an addressing of the active memristive material portions 130 via a crossbar electrode structure.

As illustrated in FIG.8B and FIG.8C, the vacancy traps T may be caused by local diffusion of metal ions, e.g., titanium ions, into the memristive material layer 400 during the fabrication of the memristive material layer 400. After fabrication, the vacancy traps T may be substantially locally fixed to allow for an operation of the memristive structure.

As illustrated in FIG.8B, the metal ions may be introduced into the first electrode 110 or first control line 111 to introduce the traps T into a region of the memristive material layer 400 adjacent to the first electrode 110 or the first control line 111. After the memristive material layer 400 is formed, the metal ions are diffused D out of the first electrode 110 or first control line 111 into the memristive material layer 400. Thereby, local implantations of metal ions and a local generation of traps T may be caused in the memristive material layer 400.

As illustrated in FIG.8C, the metal ions may be introduced into the second electrode 120 or second control line 121 to introduce the traps T into a region of the memristive material layer 400 adjacent to the second electrode 110 or the second control line 111. The metal ions are diffused D out of the second electrode 110 or second control line 111 into the memristive material layer 400. Thereby, local implantations of metal ions and a local generation of traps T can be caused in the memristive material layer 400.

**FIG.9A** and **FIG.9B** show a comparison of current/voltage (I/V) characteristics of a memristive structure 100 having a thickness (see distance 101d as described herein) above a critical thickness - illustrated in FIG.9A - and a memristive structure having a thickness below the critical thickness - illustrated in FIG.9B.

The measured I/V characteristics show a hysteresis loop, wherein the electrical characteristics of the memristive structure changes upon exceeding the critical thickness, e.g., in some aspects the critical thickness may be 150 nm or more than 150 nm, e.g., 200 nm, or 250 nm. The change of the electrical characteristics of the memristive structure is illustrated in FIG.9A and FIG.9B with respect to the sequence in which the parts 1 to 4 of the hysteresis loop are connected together.

In the case that the memristive structure 100 has a thickness above a critical thickness (see FIG.9A), the memristive structure 100 may switch from a low resistance state (LRS) to a high resistance state (HRS) continuously while lowering the voltage that drops over the memristive portion from a positive to a negative voltage. In a similar way, the memristive structure 100 may switch from a high resistance state (HRS) to a low resistance state (LRS) continuously while increasing the voltage that drops over the memristive portion from a negative to a positive voltage. Therefore, a voltage loop sequence Vₘₐₓ to V=0 followed by V=0 to -Vₘₐₓ followed by -Vₘₐₓ to V=0 and back from V=0 to Vₘₐₓ may cause a current loop with a LRS branch (see branch 1) corresponding to the voltage change from Vₘₐₓ to V=0, a HRS branch (see branch 2) corresponding to the voltage change from V=0 to -Vₘₐₓ, a LRS branch (see branch 3) corresponding to the voltage change from -Vₘₐₓ to V=0, and a HRS branch (see branch 4) corresponding to the voltage change from V=0 to Vₘₐₓ.

In contrast, for the memristive structure that has a thickness below a critical thickness (see FIG.9B), the same voltage sequence may cause a current loop with a LRS branch (see branch 1) corresponding to the voltage change from Vₘₐₓ to V=0, another LRS branch (see branch 2) corresponding to the voltage change from V=0 to -Vₘₐₓ, a HRS branch (see branch 3) corresponding to the voltage change from -Vₘₐₓ to V=0, and another HRS branch (see branch 4) corresponding to the voltage change from V=0 to Vₘₐₓ. In other words, the memristive structure shown as a comparison may show a commonly known behavior, where the memristive structure may not switch from a low resistance state (LRS) to a high resistance state (HRS) while lowering the voltage that drops over the memristive portion from a positive to a negative voltage and vice versa. The memristive structure shown as a comparison can only be switched from an LRS state to an HRS state or from a HRS to a LRS state by applying the maximum voltage ±Vₘₐₓ.

The memristive structure 100 that has a thickness above a critical thickness (see FIG.9A) may have an electrical characteristic that is needed to efficiently implement neuronal network functions or in general artificial intelligence (AI) applications since it can be programmed during a training procedure without the need of applying a maximum voltage to switch the memristive material portion 130 from LRS to HRS or HRS to LRS states.

The I/V characteristics shown in FIG.9A can be realized in a memristive crossbar array 500 as described herein. It is noted that FIG.9A shows a hysteresis loop with a positive part (branches 1 and 4) associated with positive voltages and a negative part (branches 2 and 3) associated with negative voltages. In the case that only a positive read voltage is used to read the memristive structure 100, it may be sufficient for an operation of the memristive structure 100 if the I/V characteristics includes only the positive part; and in the case that only a negative read voltage is used to read the memristive structure 100, it may be sufficient for an operation of the memristive structure 100 if the I/V characteristics includes only the negative part. However, an I/V characteristics that includes both the positive and the negative part, as illustrated in FIG.9A allows for an operation, e.g., a read out, with a positive and/or negative read voltages.

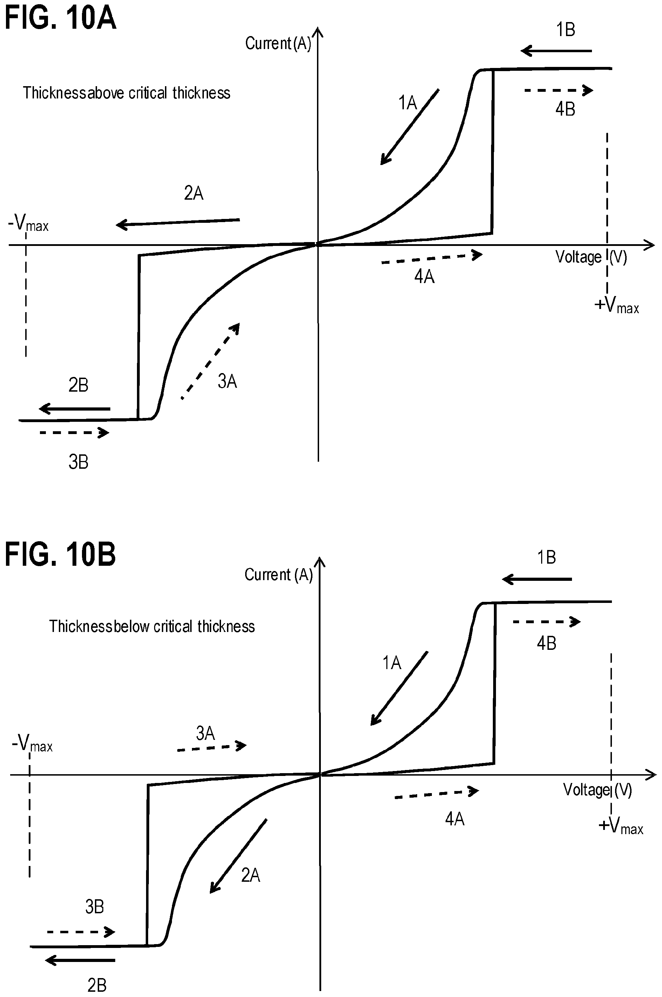

The memristive material portion 130 may be a portion of a memristive layer including (or consisting of) BiFeO₃ with a thickness of, for example, about 500 nm. To investigate whether the current changes continuously as a function of linear ramps of the applied voltage (as described with reference to FIG.9A), a voltage was applied to a word-line j (e.g., the second control line 121) of the memristive crossbar array 500 and a bit-line i (e.g., the first control line 111) of the memristive crossbar array 500 for memristive structures (i,j) at each crossing point of the memristive crossbar array 500. The voltage was ramped linearly in time from 0 V to +Vₘₐₓ (e.g., +5 V) and from +Vₘₐₓ to 0 V and from 0 V to -Vₘₐₓ (e.g., -5 V) and from -Vₘₐₓ to 0 V. The measured current can be analyzed and shows a continuous change in the current for all memristive structures (i,j) of the memristive crossbar array 500. In contrast, **FIG.10A** and **FIG.10B** show I/V characteristics of memristive structures having non-analog (e.g., digital) behavior that shows a non-continuous change (e.g., a step) in the current/voltage loop.

**FIG.11A** and **FIG.11B** show a comparison of read (r) characteristics of a memristive structure 100 that shows an analog behavior and has a thickness (see distance 101d as described herein) above a critical thickness - illustrated in FIG.11A - and a memristive structure that shows an analog behavior but has a thickness below the critical thickness - illustrated in FIG.11B with different polarity of the initialization (Vᵢₙᵢ = +|Vₘₐₓ|, Vᵢₙᵢ = -|Vₘₐₓ|) and of the read voltage (V_{read} = +|V_{read}|, V_{read} = -|V_{read}|). Different write voltages between -|Vₘₐₓ| and +|Vₘₐₓ| are applied.

FIG.11A shows a first graph 1101a associated with a transition of the memristive structure 100 between an LRS state (Vᵢₙᵢ=+|Vₘₐₓ|) and an HRS state by applying different write voltages between +|Vₘₐₓ| and -|Vₘₐₓ| after each positive initialization and positive read voltage. Each sequence includes first a positive initialization (Vᵢₙᵢ = +|Vₘₐₓ|), a write voltage in predefined steps between -|Vₘₐₓ| and +|Vₘₐₓ| and a positive read voltage to read out the read current. The positive read voltage may be, for example, +2 V and the positive initialization voltage may be, for example, +5.5 V and +|Vₘₐₓ| may be, for example, +5.5 V, and -|Vₘₐₓ| may be, for example, -5.5 V; however, other voltage ranges may be used as well.

FIG.11A shows a second graph 1102a associated with a transition of the memristive structure 100 between an LRS state (Vᵢₙᵢ=-|Vₘₐₓ|) and an HRS state by applying a first write voltages between +|Vₘₐₓ| and -|Vₘₐₓ| after each negative initialization and negative read voltage. Each sequence includes first a negative initialization (Vᵢₙᵢ = -|Vₘₐₓ|), a write voltage in predefined steps between -|Vₘₐₓ| and +|Vₘₐₓ| and a negative read voltage to read out the read current. The negative read voltage may be, for example, -2 V and the negative initialization voltage may be, for example, -5.5 V and -|Vₘₐₓ| may be, for example, -5.5 V, and +|Vₘₐₓ| may be, for example, +5 V; however, other voltage ranges may be used as well.

FIG.11A shows a third graph 1103a associated with a transition of the memristive structure 100 between an HRS state (Vᵢₙᵢ=-|Vₘₐₓ|) and an LRS state by applying different write voltages between -|Vₘₐₓ| and +|Vₘₐₓ| after each negative initialization and positive read voltage. Each sequence includes first a negative initialization (Vᵢₙᵢ = -|Vₘₐₓ|), a write voltage in predefined steps between -|Vₘₐₓ| and +|Vₘₐₓ| and a positive read voltage to read out the read current. The positive read voltage may be, for example, +2 V and the negative initialization voltage may be, for example, -5.5 V and -|Vₘₐₓ| may be, for example, -5.5 V, and +|Vₘₐₓ| may be, for example, +5.5 V; however, other voltage ranges may be used as well.

FIG.11A shows a fourth graph 1104a associated with a transition of the memristive structure 100 between an HRS state (Vᵢₙᵢ=-|Vₘₐₓ|) and an LRS state by applying different write voltages between -|Vₘₐₓ| and +|Vₘₐₓ| after each positive initialization and negative read voltage. Each sequence includes first a positive initialization (Vᵢₙᵢ = +|Vₘₐₓ|), a write voltage in predefined steps between -|Vₘₐₓ| and +|Vₘₐₓ| and a negative read voltage to read out the read current. The negative read voltage may be, for example, -2 V and the positive initialization voltage may be, for example, +5.5 V and +|Vₘₐₓ| may be, for example, +5.5 V, and -|Vₘₐₓ| may be, for example, -5.5 V; however, other voltage ranges may be used as well.

FIG.11A illustrates that the memristive structure 100, according to various aspects, shows an analog behavior and a symmetric read characteristic. The symmetric read characteristic may be an example of a read current vs. write voltage characteristic having at least one change of curvature. As an example, the same read currents may be obtained independently from a starting state of the memristive structure 100, e.g., the read current vs. write voltage curves are the same for a writing that starts from the HRS and a writing that starts from the LRS. Furthermore, there is a large range of write voltage where the read current changes linearly, namely V_{write}=-4 V to +2 V (see graphs 1101a, 1102a), V_{write}=+2 V to +5 V (see graph 1103a), and V_{write}=-5 V to -2 V (see graph 1104a). This may be linked to the I/V characteristics as described herein with reference to FIG.9A.

In contrast, in the case that a memristive structure has no symmetric read characteristic or no curvature change in the read current vs. write voltage characteristic, e.g., a memristive structure having a too thin memristive material portion, which may be linked to the I/V characteristics as described herein with reference to FIG.9B, the read current vs. write voltage characteristics may depend on an initial state of the memristive structure, as illustrated in FIG.11B in graphs 1101b, 1102b, 1103b, 1104b comparative to graphs 1101a, 1102a, 1103a, 1104a of FIG.11A. The change of the read out current memristive structure depends on the polarity of initialization and read voltage.

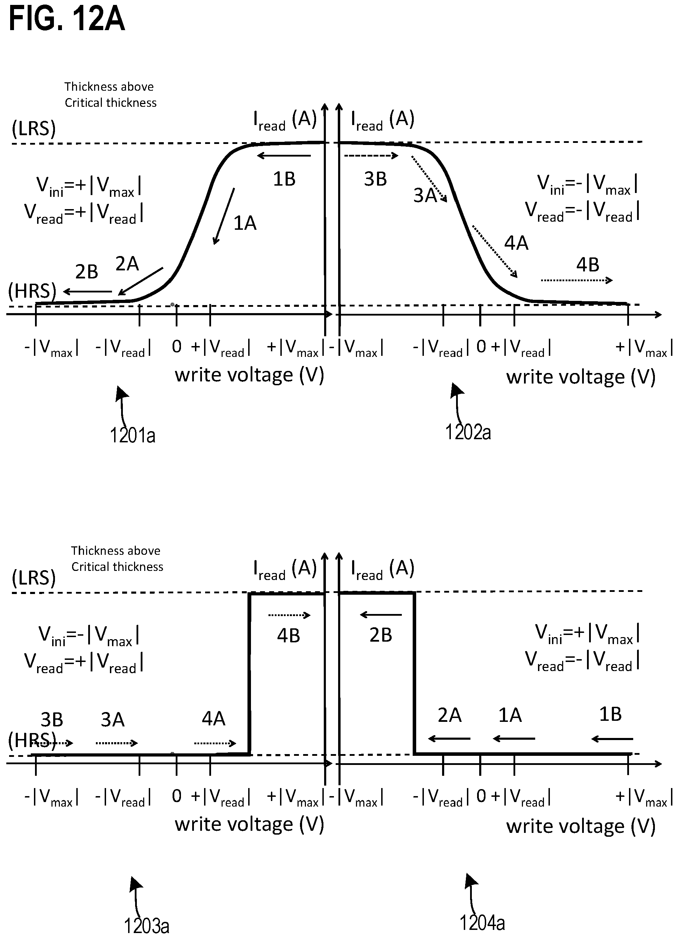

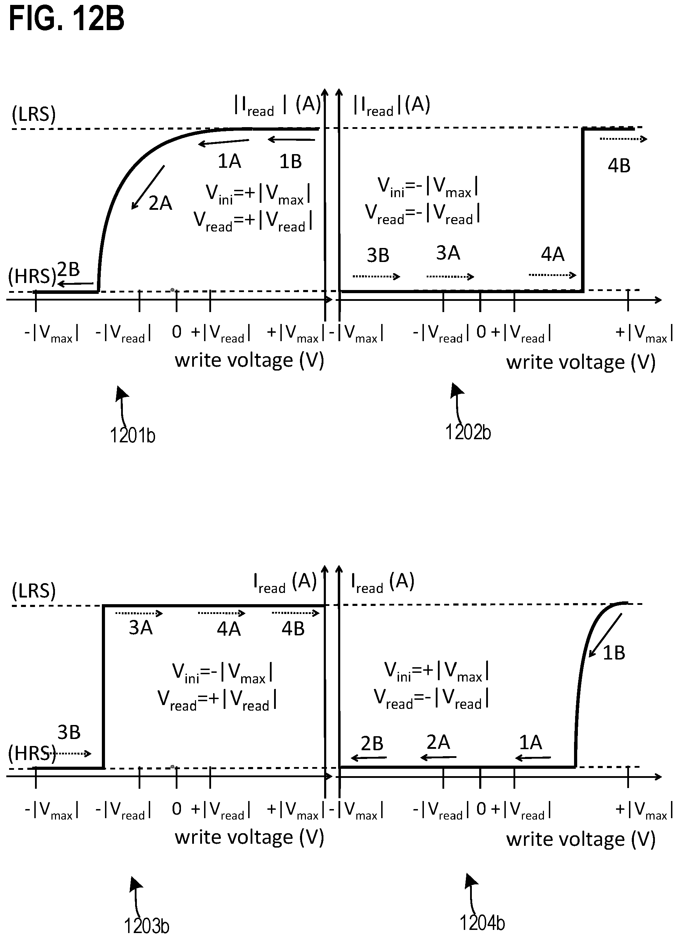

In contrast to FIG.11A and FIG.11B that show read characteristic for memristive structures with an analog switching behavior, **FIG.12A** and **FIG.12B** show read characteristics of memristive structures having non-analog (e.g., digital) behavior that shows a non-continuous change (e.g., a step) in the current/voltage loop in graphs 1201a, 1202a, 1203a, 1204a, 1201b, 1202b, 1203b, 1204b comparative to graphs 1101a, 1102a, 1103a, 1104a, 1101b, 1102b, 1103b, 1104b of FIGs.11A and 11B.

As illustrated above, the read current of memristive structures (i,j) included in a memristive crossbar array 500 may continuously change for different write voltage amplitudes of positive polarity after initialization into the HRS and of negative polarity after initialization into the LRS. The voltage is applied, for example, to word-line (j) and bit-line (i) to address memristive structure (i,j) in each crossing point of the memristive crossbar array 500. As described above, the memristive layer may be a BiFeO₃ layer with a thickness of about 500 nm or any other suitable thickness above the critical thickness. The BiFeO₃ memristive structure can be initialized with an initialization voltage (e.g., a positive initialization, e.g., Vᵢₙᵢ= +5.5 V, or a negative initialization, e.g. Vᵢₙᵢ=-5.5 V). Different write currents ranging from V_{write}=-5.5 V to V_{write}=+5.5 V can be applied. The read current I_{read} can be measured by applying a read voltage pulse (e.g., a positive read voltage, e.g., V_{read} = +2 V, or a negative read voltage, e.g. V_{read}=-2 V).

To determine whether or not a memristive structures 100 of a memristive crossbar array 500 have a symmetric read characteristic and/or at least one curvature change in the read characteristic, each memristive structure (i,j) may be initialized by applying a write voltage pulse with amplitude +Vₘₐₓ in LRS and changed from LRS to HRS with write voltage pulses with amplitude between +Vₘₐₓ and -Vₘₐₓ (e.g., +6.0V, +5.5 V, +5.0 V, +4.5 V, +4.0 V, +3.5 V, +3.0 V, +2.5 V, +2.0 V, +1.5 V, +1.0 V, +0.5 V, 0 V, -0.5 V, -1.0 V, -1.5 V, -2.0 V, -2.5 V, -3.0 V, -3.5 V, -4.0 V, -4.5 V, -5. 0 V, -5.5 V, -6.0 V) to a higher resistance state in the range between LRS (write voltage amplitude +6.0 V) and HRS (write voltage amplitude -Vₘₐₓ), and then the read current is determined by applying a read voltage pulse of V_{read} = +2 V or any other suitable read voltage. This corresponds to branch 1 in FIG.9A.

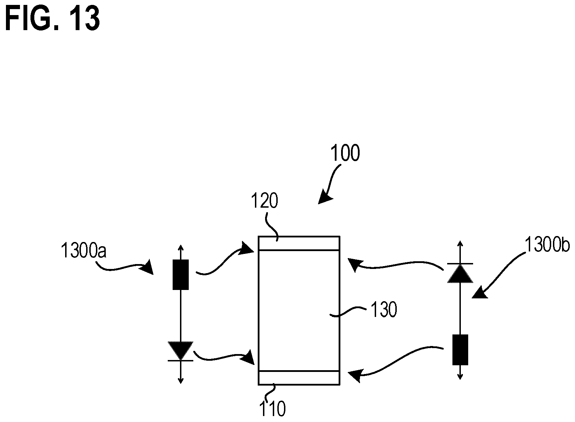

Each memristive structure (i,j) may be initialized by applying a write voltage pulse with amplitude +Vₘₐₓ in the LRS (see equivalent circuit 1300a in FIG.13) and subsequently changed from LRS to HRS (see equivalent circuit 1300b in FIG. 13) with write voltage pulses with amplitude between +Vₘₐₓ and -Vₘₐₓ (e.g., +6.0V, +5.5 V, +5.0 V, +4.5 V, +4.0 V, +3.5 V, +3.0 V, +2.5 V, +2.0 V, +1.5 V, +1.0 V, +0.5 V, 0 V, -0.5 V, -1.0 V, -1.5 V, -2.0 V, -2.5 V, -3.0 V, -3.5 V, -4.0 V, -4.5 V, -5. 0 V, -5.5 V, -6.0 V) were set to a higher resistance state in the range between LRS (write voltage amplitude +6.0 V) and HRS (write voltage amplitude -Vₘₐₓ). When a negative read voltage pulse of V_{read} = -2 V is applied, branch 2 in the IV characteristics is read out (see FIG.9A).

Each memristive structure (i,j) may be initialized by applying a write voltage pulse with amplitude -Vₘₐₓ in the HRS (see equivalent circuit 1300b in FIG.13) and subsequently changed from HRS to LRS (see equivalent circuit 1300a in FIG. 13) with write voltage pulses with amplitude between -Vₘₐₓ and +Vₘₐₓ (e.g., -6.0V, -5.5 V, -5.0 V, -4.5 V, -4.0 V, -3.5 V, -3.0 V, -2.5 V, -2.0 V, -1.5 V, -1.0 V, -0.5 V, 0 V, +0.5 V, +1.0 V, +1.5 V, +2.0 V, +2.5 V, +3.0 V, +3.5 V, +4.0 V, +4.5 V, +5. 0 V, +5.5 V, +6.0 V) were set to a higher resistance state in the range between HRS (write voltage amplitude -6.0 V) and LRS (write voltage amplitude +Vₘₐₓ). When a negative read voltage pulse of V_{read} = -2 V is applied, branch 3 in the IV characteristics is read out (see FIG.9A).

Each memristive structure (i,j) may be initialized by applying a write voltage pulse with amplitude -Vₘₐₓ in the HRS and subsequently changed from HRS to LRS with write voltage pulses with amplitude between -Vₘₐₓ and +Vₘₐₓ (e.g., -6.0V, -5.5 V, -5.0 V, -4.5 V, -4.0 V, - 3.5 V, -3.0 V, -2.5 V, -2.0 V, -1.5 V, -1.0 V, -0.5 V, 0 V, +0.5 V, +1.0 V, +1.5 V, +2.0 V, +2.5 V, +3.0 V, +3.5 V, +4.0 V, +4.5 V, +5. 0 V, +5.5 V, +6.0 V) were set to a lower resistance state in the range between HRS (write voltage amplitude -6.0 V) and LRS (write voltage amplitude +Vₘₐₓ), and then the positive read current may be determined by applying a read voltage pulse of V_{read} = +2 V or any other suitable read voltage. This corresponds to branch 4 in FIG.9A.

For each memristive structure (i,j) of an NxM crossbar structure as described herein, according to various aspects, the read current may depend symmetrically on the amplitude of the write voltage when the polarity of the write voltage is changed. This shows a possibility of fabricating crossbar structures with ideal analog memristive structure 100.

Various aspects described herein may be related to measures in a memristive crossbar array 500 that support the formation of an electric field in the selected memristive structure (i,j) when a voltage is applied to the word-line (j) (j=1..M) and the bit-line (i) (i=1..N) of the MxN memristive crossbar array 500 corresponding to the selected memristive structure (i,j). Moreover, the proposed aspects may prevent a formation of a substantive electric field outside of a selected memristive structure (i,j) when a voltage is applied to word-line (j) and a bit line (i) of the crossbar structure corresponding to the selected memristive structure (i,j).

Such measures may include the local structuring of at least one of the bit-line, the memristive material layer, and/or the word-line. Examples may include a local elevation of the bit-line. Examples may include a local removal of the memristive layer (e.g., from the upper surface). Examples may include a formation of an insulator layer and/or a local opening at the crossing points of the crossbar structure and in the area of the contact pads of the word-lines and/or bit-lines. Examples may include a crossbar structure with combined measures.

Other measures may include a local introduction of oxygen vacancies into the memristive material, e.g., via Ar⁺-ion-implantation after forming the memristive material layer and, for example, prior to the formation of the word-lines (e.g., the second control lines 121).

Still other measures may include a local introduction of metal ion (e.g., titanium ions) into the memristive material, e.g., via ion-implantation and/or diffusion.

It is noted that the above used terms "bitline" and "wordline" are used to distinguish the control lines from one another and each bitline and/or wordline may also be any other kind of suitable control line.

**FIG.13** shows two equivalent circuits 1300a, 1300b representing the electrical condition of a memristive structure with an LRS state and an HRS state for a first initialization (see first equivalent circuit 1300a) and a second initialization (see second equivalent circuit 1300b), according to various aspects. The memristive structure 100 may be in a self-rectifying configuration. The self-rectifying configuration and/or the desired switching behavior may be caused by a formation of a diode (e.g., a Schottky contact) and a resistor at the interfaces between the first electrode 110 and the memristive material portion 130 and between the second electrode 120 and the memristive material portion 130. The diode and the resistor are coupled to one another in a series connection and provide the described HRS and LRS states for a defined polarity. The switching of the memristive structure 100 and therefore the presence of a diode-contact or a resistive contact at the respective electrode regions may be defined by the memristive material, e.g., by presence and/or absence of oxygen vacancies in the electrode regions.

Illustratively, the first equivalent circuit 1300a may correspond to a negative initialization, e.g., with Vᵢₙᵢ = -|Vₘₐₓ|, wherein the LRS state may be related to V_{read} = -|V_{read}| (see branch 3 of the I/V characteristics described herein) and the HRS state may be related to V_{read} = +|V_{read}| (see branch 4 of the I/V characteristics described herein). The second equivalent circuit 1300b may correspond to a positive initialization, e.g., with Vᵢₙᵢ = +|Vₘₐₓ|, wherein the LRS state may be related to V_{read} = ₊|V_{read}| (see branch 1 of the I/V characteristics described herein) and the HRS state may be related to V_{read} = -|V_{read}| (see branch 2 of the I/V characteristics described herein).

**FIG.14A** shows measurements of a manufactured memristive structure 100 in a memristive crossbar array 500 similar to the properties described with reference to FIG.9A. It can be seen that the manufactured memristive structure having a memristive material portion 130 with a thickness of, for example, greater than 150 nm, e.g., 500 nm shows a substantially ideal analog read characteristic.

The memristive structure 100 has a thickness above a critical thickness and switches from a low resistance state (LRS) to a high resistance state (HRS) continuously while lowering the voltage that drops over the memristive portion from a positive to a negative voltage. In a similar way, the memristive structure 100 may switch from a high resistance state (HRS) to a low resistance state (LRS) continuously while increasing the voltage that drops over the memristive portion from a negative to a positive voltage. Therefore, a voltage loop sequence Vₘₐₓ to V=0 followed by V=0 to -Vₘₐₓ followed by -Vₘₐₓ to V=0 and back from V=0 to Vₘₐₓ may cause a current loop with a LRS branch (see branch 1) corresponding to the voltage change from Vₘₐₓ to V=0, a HRS branch (see branch 2) corresponding to the voltage change from V=0 to -Vₘₐₓ, a LRS branch (see branch 3) corresponding to the voltage change from -Vₘₐₓ to V=0, and a HRS branch (see branch 4) corresponding to the voltage change from V=0 to Vₘₐₓ. +|Vₘₐₓ| has been set to +5V and -|Vₘₐₓ| has been set to -5V.

**FIG.14B** show measurements of a manufactured memristive structure 100 in a memristive crossbar array 500 similar to the properties described with reference to FIG.11A. It can be seen that the manufactured memristive structure having a memristive material portion 130 with a thickness of, for example, greater than 150 nm, e.g., 500 nm shows a substantially ideal analog read characteristic. The positive initialization voltage has been set to +|Vₘₐₓ| = +5V. The negative initialization voltage has been set to -|Vₘₐₓ| = -5V. For positive initialization and positive read out the curvature changes at -2 V (see graph 1401b). For negative initialization and negative read out the curvature changes at -2 V (see graph 1402b). For negative initialization and positive read out the curvature changes at ca. +4 V (see graph 1403b). For positive initialization and negative read out the curvature changes at about -4 V (see graph 1404b).

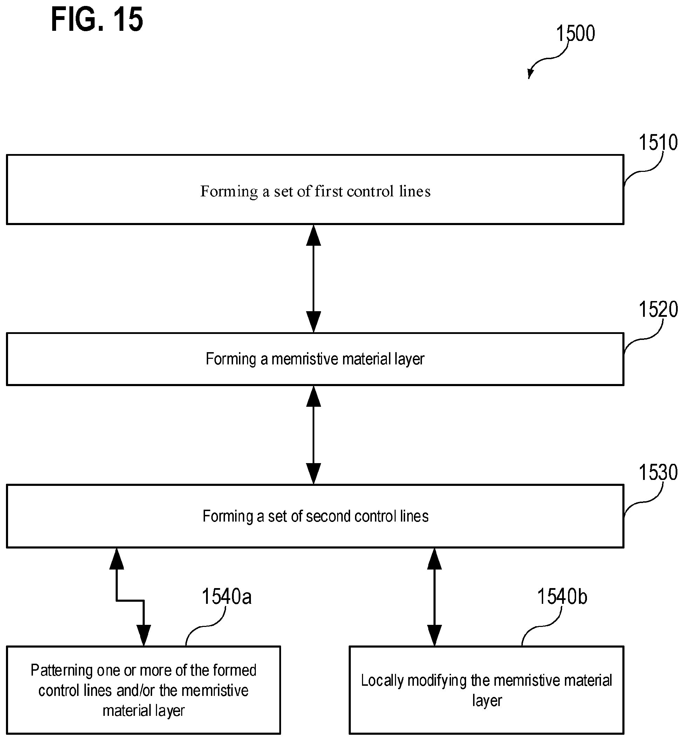

FIG.15 shows a schematic flow diagram of a method 1500 for forming a memristive structure (e.g., memristive structure 100) or a memristive crossbar array (e.g., memristive crossbar array 500). The method 1500 may include, in 1510, forming a set of first control lines (e.g., first control lines 111). The method 1500 may include, in 1520, forming a memristive material layer (e.g., memristive material layer 400 including memristor material portions 130) over the set of first control lines. The method 1500 may include, in 1530, forming a set of second control lines (e.g., second control lines 121) over the memristive material layer.

The method 1500 may further include, in 1540a, patterning one or more of the formed control lines and/or the memristive material layer and/or, in 1540b, locally modifying (e.g., doping) the memristive material layer.

As an example, the method 1500 may include, in 1540a, patterning one or more first control lines of the set of first control lines, and/or patterning one or more second control lines of the set of second control lines, and/or patterning the memristive material layer. This may allow to thereby modify an electric field characteristic of an electric field generated in cross-point regions of the memristive material layer via the one or more first control lines of the set of first control lines and via the one or more second control lines of the set of second control lines.

As an example, the method 1500 may include, in 1540b, locally doping the memristive material layer by at least one of crystallographic vacancies and/or crystallographic traps for trapping crystallographic vacancies in cross-point regions of the memristive material layer. A drifting and trapping process of the crystallographic vacancies in the cross-point regions may allow for a non-linear switching, e.g., a self-rectifying switching, of the one or more memristive structures of a memristive crossbar array.

While the invention has been particularly shown and described with reference to specific aspects, it should be understood by those skilled in the art that various changes in form and detail may be made therein without departing from scope of the invention as defined by the appended claims. The scope of the invention is thus indicated by the appended claims and all changes, which come within the meaning of the claims, are therefore intended to be embraced.

## Claims

1. A memristive crossbar array (500), comprising:
first control lines (111(i)) and second control lines (121(j)) in a crossbar configuration defining a plurality of cross-point regions (100r(i,j));
a memristive material portion (130(i,j)) disposed in each of the plurality of cross-point regions (100r(i,j)) between a corresponding pair of a first control line of the first control lines (111(i)) and a second control line of the second control lines (121(j)) to form a corresponding memristive structure (100(i,j)) and to generate selectively a Schottky-type diode either with maximum barrier height at the first control line or at the second control line such that the memristive structure (100(i,j)) exhibits a nonlinear switching behavior and is self-rectifying,
wherein each memristive material portion (130(i,j)) comprises bismuth ferrite and has in its cross-point region (100r(i,j)) a thickness (101m) to width (243, 245) ratio greater than one, whereby each corresponding memristive structure has at least one curvature change between left-curved and right-curved in the current-voltage-curve of the read characteristic between a low resistance state and a high resistance state after positive initialization and positive read out and/or after negative initialization and negative read out.

2. The memristive crossbar array (500) of claim 1, further comprising:
a continuous layer of a basic material (400), wherein each memristive material portion (130(i,j)) is a portion of the continuous layer of the basic material (400),
wherein the continuous layer of the basic material (400) comprises at least one other portion (430) neighboring the memristive material portions (130(i,j)), wherein the at least one other portion (430) has a thickness that is greater than the thickness of the memristive material portions.

3. The memristive crossbar array (500) of claim 2,
wherein in each of the plurality of cross-point regions (100r(i,j)) the first control lines (111(i)) are connected to a respective first electrode (110(i,j)) of the corresponding memristive structure (100(i,j)), wherein a distance of the first control lines (111(i)) from a lower surface of the continuous layer of the basic material (400) facing away from the first control lines (111(i)) is greater than a distance of the first electrode (110(i,j)) from the lower surface of the continuous layer of the basic material (400); and/or
wherein in each of the plurality of cross-point regions (100r(i,j)) the second control lines (121(j)) are connected to a respective second electrode (120(i,j)) of the corresponding memristive structure (100(i,j)), wherein a distance of the second control lines (121(j)) from an upper surface of the continuous layer of the basic material (400) facing away from the second control lines (121(j)) is greater than a distance of the second electrode (120(i,j)) from the upper surface of the continuous layer of the basic material (400).

4. The memristive crossbar array (500) of claim 1 or 3,
wherein the first control lines (111(i)) and/or the second control lines (121(j)) are configured to channel an electric filed applicable via the corresponding pair of one of the first control lines (111(i)) and one of the second control lines (121(j)) in the cross-point region (100r(i,j); or
wherein in each of the plurality of cross-point regions (100r(i,j)) at least one of the corresponding pair of one of the first control lines (111(i)) and one of the second control lines (121(j)) are connected to a first electrode (110(i,j)) and a second electrode (120(i,j)) of the corresponding memristive structure (100(i,j)) respectively, wherein the first electrode (110(i,j)) and/or the second electrode (120(i,j)) are configured to channel an electric filed applicable via the corresponding pair of one of the first control lines (111(i)) and one of the second control lines (121(j)) in the cross-point region (100r(i,j).

5. The memristive crossbar array (500) of any one of claims 1 to 4,
wherein the thickness (101m) of each memristive material portion is greater than 150 nm, and/or
wherein in each of the plurality of cross-point regions (100r(i,j)) the corresponding pair of one of the first control lines (111(i)) and one of the second control lines (121(j)) have a distance (101d) from one another that is greater than 150 nm.

6. The memristive crossbar array (500) of any one of claims 1 to 5,
wherein in each of the plurality of cross-point regions (100r(i,j)) the corresponding pair of one of the first control lines (111(i)) and one of the second control lines (121(j)) act as a first electrode (110(i,j)) and as a second electrode (120(i,j)) of the corresponding memristive structure (100(i,j)) respectively; or
wherein in each of the plurality of cross-point regions (100r(i,j)) the corresponding pair of one of the first control lines (111(i)) and one of the second control lines (121(j)) are connected to a first electrode (110(i,j)) and a second electrode (120(i,j)) of the corresponding memristive structure (100(i,j)) respectively,
wherein, preferably, the first electrode (110(i,j)) and the second electrode (120(i,j)) have a distance (101d) from one another that is greater than 150 nm.

7. The memristive crossbar array (500) of any one of claims 1 to 6,
wherein the corresponding pair of one of the first control lines (111(i)) and one of the second control lines (121(j)) allow for an individual electrical addressing of the corresponding memristive structure (100(i,j)).

8. The memristive crossbar array (500) of any one of claims 1 to 7,
wherein an overlap of the corresponding pair of one of the first control lines (111(i)) and one of the second control lines (121(j)) with one another defines a cross-point area (240) and wherein a dimension of the memristive material portion parallel to the cross-point area is greater than a dimension of the cross-point area (240).

9. The memristive crossbar array (500) of claim 1, comprising:
a continuous layer of a basic material (400), wherein each memristive material portion (130(i,j)) is a portion of the continuous layer of the basic material (400).

10. The memristive crossbar array (500) of claim 9,
wherein the basic material (400) has memristive properties.

11. The memristive crossbar array (500) of claim 9,
wherein the basic material (400) has memristive properties, and
wherein the basic material (400) comprises a local modification in the cross-point regions (100r(i,j)).

12. The memristive crossbar array (500) of claim 9,
wherein the basic material (400) has non-memristive properties, and
wherein the basic material (400) comprises a local modification in the cross-point regions (100r(i,j)) such that a modified basic material in the cross-point regions (100r(i,j)) has memristive properties.

13. The memristive crossbar array (500) of claim 11 or 12,
wherein the local modification comprises a local metal ion doping and/or wherein the local modification comprises locally induced vacancies; or
wherein the basic material is an oxide and wherein the local modification comprises locally induced oxygen vacancies.

14. The memristive crossbar array (500) of claim 13,
wherein the local modification of the basic material further comprises locally induced traps configured to hinder oxygen vacancies from drifting.

15. The memristive crossbar array (500) of any one of claims 9 to 14,
wherein the continuous layer of the basic material (400) comprises at least one other portion (430) neighboring the memristive material portions (130(i,j)), wherein the at least one other portion (430) has a thickness that is greater than the predefined range.

## Patentansprüche

1. Memristives Crossbar-Array (500), umfassend:
erste Steuerleitungen (111(i)) und zweite Steuerleitungen (121(j)) in einer Crossbar-Konfiguration, die eine Vielzahl von Kreuzungspunktregionen (100r(i,j)) definieren;
einen memristiven Materialabschnitt (130(i,j)), der in jeder der Vielzahl von Kreuzungspunktregionen (100r(i,j)) zwischen einem entsprechenden Paar einer ersten Steuerleitung der ersten Steuerleitungen (111(i)) und einer zweiten Steuerleitung der zweiten Steuerleitungen (121(j)) angeordnet ist, um eine entsprechende memristive Struktur (100(i,j)) auszubilden und eine Diode der Schottky-Art entweder mit maximaler Barrierenhöhe an der ersten Steuerleitung oder an der zweiten Steuerleitung derart selektiv zu erzeugen, dass die memristive Struktur (100(i,j)) ein nichtlineares Schaltverhalten vorweist und selbstgleichrichtend ist,
wobei jeder memristive Materialabschnitt (130(i,j)) Bismut-Ferrit umfasst und in seiner Kreuzungspunktregion (100r(i,j)) ein Verhältnis von Dicke (101m) zu Breite (243, 245) größer als eins aufweist, wodurch jede entsprechende memristive Struktur mindestens eine Krümmungsänderung zwischen linksgekrümmt und rechtsgekrümmt in der Stromspannungskurve des Lesemerkmals zwischen einem niedrigen Widerstandszustand und einem hohen Widerstandszustand nach positiver Initialisierung und positivem Auslesen und/oder nach negativer Initialisierung und negativem Auslesen aufweist.

2. Memristives Crossbar-Array (500) nach Anspruch 1, ferner umfassend:
eine kontinuierliche Schicht eines Grundmaterials (400), wobei jeder memristive Materialabschnitt (130(i,j)) ein Abschnitt der kontinuierlichen Schicht des Grundmaterials (400) ist,
wobei die kontinuierliche Schicht des Grundmaterials (400) mindestens einen anderen Abschnitt (430) umfasst, der an die memristiven Materialabschnitte (130(i,j)) angrenzt, wobei der mindestens eine andere Abschnitt (430) eine Dicke aufweist, die größer als die Dicke der memristiven Materialabschnitte ist.

3. Memristives Crossbar-Array (500) nach Anspruch 2,
wobei in jeder der Vielzahl von Kreuzungspunktregionen (100r(i,j)) die ersten Steuerleitungen (111(i)) mit einer jeweiligen ersten Elektrode (110(i,j)) der entsprechenden memristiven Struktur (100(i,j)) verbunden sind, wobei ein Abstand der ersten Steuerleitungen (111(i)) von einer unteren Oberfläche der kontinuierlichen Schicht des Grundmaterials (400), die von den ersten Steuerleitungen (111(i)) abgewandt ist, größer als ein Abstand der ersten Elektrode (110(i,j)) von der unteren Oberfläche der kontinuierlichen Schicht des Grundmaterials (400) ist; und/oder
wobei in jeder der Vielzahl von Kreuzungspunktregionen (100r(i,j)) die zweiten Steuerleitungen (121(j)) mit einer jeweiligen zweiten Elektrode (120(i,j)) der entsprechenden memristiven Struktur (100(i,j)) verbunden sind, wobei ein Abstand der zweiten Steuerleitungen (121(j)) von einer oberen Oberfläche der kontinuierlichen Schicht des Grundmaterials (400), die von den zweiten Steuerleitungen (121(j)) abgewandt ist, größer als ein Abstand der zweiten Elektrode (120(i,j)) von der oberen Oberfläche der kontinuierlichen Schicht des Grundmaterials (400) ist.

4. Memristives Crossbar-Array (500) nach Anspruch 1 oder 3,
wobei die ersten Steuerleitungen (111(i)) und/oder die zweiten Steuerleitungen (121(j)) konfiguriert sind, um ein elektrisches Feld zu leiten, das über das entsprechende Paar von einer der ersten Steuerleitungen (111(i)) und einer der zweiten Steuerleitungen (121(j)) in der Kreuzungspunktregion (100r(i,j)) anlegbar ist; oder
wobei in jeder der Vielzahl von Kreuzungspunktregionen (100r(i,j)) mindestens eine des entsprechenden Paars von einer der ersten Steuerleitungen (111(i)) und einer der zweiten Steuerleitungen (121(j)) mit einer ersten Elektrode (110(i,j)) beziehungsweise einer zweiten Elektrode (120(i,j)) der entsprechenden memristiven Struktur (100(i,j)) verbunden sind, wobei die erste Elektrode (110(i,j)) und/oder die zweite Elektrode (120(i,j)) konfiguriert sind, um ein elektrisches Feld zu leiten, das über das entsprechende Paar von einer der ersten Steuerleitungen (111(i)) und einer der zweiten Steuerleitungen (121(j)) in der Kreuzungspunktregion (100r(i,j)) anlegbar ist.

5. Memristives Crossbar-Array (500) nach einem der Ansprüche 1 bis 4,
wobei die Dicke (101m) jedes memristiven Materialabschnitts größer als 150 nm ist und/oder
wobei in jeder der Vielzahl von Kreuzungspunktregionen (100r(i,j)) das entsprechende Paar von einer der ersten Steuerleitungen (111(i)) und einer der zweiten Steuerleitungen (121(j)) einen Abstand (101d) voneinander aufweist, der größer als 150 nm ist.

6. Memristives Crossbar-Array (500) nach einem der Ansprüche 1 bis 5,
wobei in jeder der Vielzahl von Kreuzungspunktregionen (100r(i,j)) das entsprechende Paar von einer der ersten Steuerleitungen (111(i)) und einer der zweiten Steuerleitungen (121(j)) als eine erste Elektrode (110(i,j)) beziehungsweise als eine zweite Elektrode (120(i,j)) der entsprechenden memristiven Struktur (100(i,j)) wirkt; oder
wobei in jeder der Vielzahl von Kreuzungspunktregionen (100r(i,j)) das entsprechende Paar von einer der ersten Steuerleitungen (111(i)) und einer der zweiten Steuerleitungen (121(j)) mit einer ersten Elektrode (110(i,j)) beziehungsweise einer zweiten Elektrode (120(i,j)) der entsprechenden memristiven Struktur (100(i,j)) verbunden ist,
wobei vorzugsweise die erste Elektrode (110(i,j)) und die zweite Elektrode (120(i,j)) einen Abstand (101d) voneinander aufweisen, der größer als 150 nm ist.

7. Memristives Crossbar-Array (500) nach einem der Ansprüche 1 bis 6,
wobei das entsprechende Paar von einer der ersten Steuerleitungen (111(i)) und einer der zweiten Steuerleitungen (121(j)) ein individuelles elektrisches Adressieren der entsprechenden memristiven Struktur (100(i,j)) ermöglicht.

8. Memristives Crossbar-Array (500) nach einem der Ansprüche 1 bis 7,
wobei eine Überlappung des entsprechenden Paars von einer der ersten Steuerleitungen (111(i)) und einer der zweiten Steuerleitungen (121(j)) miteinander einen Kreuzungspunktbereich (240) definiert und wobei eine Abmessung des memristiven Materialabschnitts parallel zu dem Kreuzungspunktbereich größer als eine Abmessung des Kreuzungspunktbereichs (240) ist.

9. Memristives Crossbar-Array (500) nach Anspruch 1, umfassend:
eine kontinuierliche Schicht eines Grundmaterials (400), wobei jeder memristive Materialabschnitt (130(i,j)) ein Abschnitt der kontinuierlichen Schicht des Grundmaterials (400) ist.

10. Memristives Crossbar-Array (500) nach Anspruch 9,
wobei das Grundmaterial (400) memristive Eigenschaften aufweist.

11. Memristives Crossbar-Array (500) nach Anspruch 9,
wobei das Grundmaterial (400) memristive Eigenschaften aufweist und
wobei das Grundmaterial (400) eine lokale Modifikation in den Kreuzungspunktregionen (100r(i,j)) umfasst.

12. Memristives Crossbar-Array (500) nach Anspruch 9,
wobei das Grundmaterial (400) nichtmemristive Eigenschaften aufweist und
wobei das Grundmaterial (400) eine derartige lokale Modifikation in den Kreuzungspunktregionen (100r(i,j)) umfasst, dass ein modifiziertes Grundmaterial in den Kreuzungspunktregionen (100r(i,j)) memristive Eigenschaften aufweist.

13. Memristives Crossbar-Array (500) nach Anspruch 11 oder 12,
wobei die lokale Modifikation ein lokales Metallionendotieren umfasst und/oder wobei die lokale Modifikation lokal induzierte Leerstellen umfasst; oder
wobei das Grundmaterial ein Oxid ist und wobei die lokale Modifikation lokal induzierte Sauerstoffleerstellen umfasst.

14. Memristives Crossbar-Array (500) nach Anspruch 13,
wobei die lokale Modifikation des Grundmaterials ferner lokal induzierte Fallen umfasst, die konfiguriert sind, um Sauerstoffleerstellen am Driften zu hindern.

15. Memristives Crossbar-Array (500) nach einem der Ansprüche 9 bis 14,
wobei die kontinuierliche Schicht des Grundmaterials (400) mindestens einen anderen Abschnitt (430) umfasst, der an die memristiven Materialabschnitte (130(i,j)) angrenzt, wobei der mindestens eine andere Abschnitt (430) eine Dicke aufweist, die größer als der vordefinierte Umfang ist.

## Revendications

1. Réseau matriciel memristif (500), comprenant :
des premières lignes de commande (111(i)) et des secondes lignes de commande (121(j)) dans une configuration matricielle définissant une pluralité de régions de point de croisement (100r(i,j)) ;
une partie de matériau memristif (130(i,j)) disposée dans chacune parmi la pluralité de régions de point de croisement (100r(i,j)) entre une paire correspondante constituée d'une première ligne de commande parmi les premières lignes de commande (111(i)) et d'une seconde ligne de commande parmi les secondes lignes de commande (121(j)) afin de former une structure memristive (100(i,j)) correspondante et de générer sélectivement une diode de type Schottky ayant une hauteur de barrière maximale soit au niveau de la première ligne de commande, soit au niveau de la seconde ligne de commande de telle sorte que la structure memristive (100(i,j)) fait preuve d'un comportement de commutation non linéaire et est auto-rectificatrice,
dans lequel chaque partie de matériau memristif (130(i,j)) comprend de la ferrite de bismuth et a dans sa région de point de croisement (100r(i,j)) un rapport épaisseur (101m) sur largeur (243, 245) supérieur à un, moyennant quoi chaque structure memristive correspondante a au moins un changement de courbure entre une courbe gauche et une courbe droite dans la courbe tension-courant de la caractéristique de lecture entre un état de faible résistance et un état de résistance élevée après initialisation positive et lecture positive et/ou après initialisation négative et lecture négative.

2. Réseau matriciel memristif (500) selon la revendication 1, comprenant en outre :
une couche continue d'un matériau de base (400), dans lequel chaque partie de matériau memristif (130(i,j)) est une partie de la couche continue du matériau de base (400),
dans lequel la couche continue du matériau de base (400) comprend au moins une autre partie (430) voisine des parties de matériau memristif (130(i,j)), dans lequel l'au moins une autre partie (430) a une épaisseur qui est supérieure à l'épaisseur des parties de matériau memristif.

3. Réseau matriciel memristif (500) selon la revendication 2,
dans lequel, dans chacune de la pluralité de régions de point de croisement (100r(i,j)), les premières lignes de commande (111(i)) sont connectées à une première électrode respective (110(i,j)) de la structure memristive (100(i,j)) correspondante, dans lequel une distance des premières lignes de commande (111(i)) à une surface inférieure de la couche continue du matériau de base (400) située à l'opposé des premières lignes de commande (111(i)) est supérieure à une distance de la première électrode (110(i,j)) à la surface inférieure de la couche continue du matériau de base (400) ; et/ou
dans lequel, dans chacune de la pluralité de régions de point de croisement (100r(i,j)), les secondes lignes de commande (121(j)) sont connectées à une seconde électrode respective (120(i,j)) de la structure memristive correspondante (100(i,j)), dans lequel une distance des secondes lignes de commande (121(j)) à une surface supérieure de la couche continue du matériau de base (400) située à l'opposé des secondes lignes de commande (121(j)) est supérieure à une distance de la seconde électrode (120(i,j)) à la surface supérieure de la couche continue du matériau de base (400).

4. Réseau matriciel memristif (500) selon la revendication 1 ou 3,
dans lequel les premières lignes de commande (111(i)) et/ou les secondes lignes de commande (121(j)) sont configurées pour canaliser un champ électrique applicable par l'intermédiaire de la paire correspondante constituée de l'une des premières lignes de commande (111(i)) et de l'une des secondes lignes de commande (121(j)) dans la région de point de croisement (100r(i,j)) ; ou
dans lequel, dans chacune de la pluralité de régions de point de croisement (100r(i,j)), au moins l'une parmi la paire correspondante constituée de l'une des premières lignes de commande (111(i)) et de l'une des secondes lignes de commande (121(j)) sont respectivement connectées à une première électrode (110(i,j)) et à une seconde électrode (120(i,j)) de la structure memristive correspondante (100(i,j)), dans lequel la première électrode (110(i,j)) et/ou la seconde électrode (120(i,j)) sont configurées pour canaliser un champ électrique applicable par l'intermédiaire de la paire correspondante constituée de l'une des premières lignes de commande (111(i)) et de l'une des secondes lignes de commande (121(j)) dans la région de point de croisement (100r(i,j).

5. Réseau matriciel memristif (500) selon l'une quelconque des revendications 1 à 4,
dans lequel l'épaisseur (101m) de chaque partie de matériau memristif est supérieure à 150 nm, et/ou
dans lequel, dans chacune de la pluralité de régions de point de croisement (100r(i,j)), la paire correspondante constituée de l'une des premières lignes de commande (111(i)) et de l'une des secondes lignes de commande (121(j)) ont une distance (101d) de l'une à l'autre supérieure à 150 nm.

6. Réseau matriciel memristif (500) selon l'une quelconque des revendications 1 à 5,
dans lequel, dans chacune de la pluralité de régions de point de croisement (100r(i,j)), la paire correspondante constituée de l'une des premières lignes de commande (111(i)) et de l'une des secondes lignes de commande (121(j)) agit respectivement comme une première électrode (110(i,j)) et comme une seconde électrode (120(i,j)) de la structure memristive correspondante (100(i,j)) ; ou
dans lequel, dans chacune de la pluralité de régions de point de croisement (100r(i,j)), la paire correspondante constituée de l'une des premières lignes de commande (111(i)) et de l'une des secondes lignes de commande (121(j)) sont connectées respectivement à une première électrode (110(i,j)) et à une seconde électrode (120(i,j)) de la structure memristive correspondante (100(i), j)),
dans lequel, de préférence, la première électrode (110(i,j)) et la seconde électrode (120(i,j)) ont une distance (101d) de l'une à l'autre supérieure à 150 nm.

7. Réseau matriciel memristif (500) selon l'une quelconque des revendications 1 à 6,
dans lequel la paire correspondante constituée de l'une des premières lignes de commande (111(i)) et de l'une des secondes lignes de commande (121(j)) permet un adressage électrique individuel de la structure memristive (100(i,j)) correspondante.

8. Réseau matriciel memristif (500) selon l'une quelconque des revendications 1 à 7,
dans lequel un chevauchement l'une avec l'autre de la paire correspondante constituée de l'une des premières lignes de commande (111(i)) et de l'une des secondes lignes de commande (121(j)) définit une zone de point de croisement (240), et dans lequel une dimension de la partie de matériau memristif parallèle à la zone de point de croisement est supérieure à une dimension de la zone de point de croisement (240).

9. Réseau matriciel memristif (500) selon la revendication 1, comprenant :
une couche continue d'un matériau de base (400), dans lequel chaque partie de matériau memristif (130(i,j)) est une partie de la couche continue du matériau de base (400).

10. Réseau matriciel memristif (500) selon la revendication 9,
dans lequel le matériau de base (400) a des propriétés memristives.

11. Réseau matriciel memristif (500) selon la revendication 9,
dans lequel le matériau de base (400) a des propriétés memristives, et
dans lequel le matériau de base (400) comprend une modification locale dans les régions de point de croisement (100r(i,j)).

12. Réseau matriciel memristif (500) selon la revendication 9,
dans lequel le matériau de base (400) a des propriétés non memristives, et
dans lequel le matériau de base (400) comprend une modification locale dans les régions de point de croisement (100r(i,j)) de telle sorte qu'un matériau de base modifié dans les régions de point de croisement (100r(i,j)) a des propriétés memristives.

13. Réseau matriciel memristif (500) selon la revendication 11 ou 12,
dans lequel la modification locale comprend un dopage local par des ions métalliques et/ou dans lequel la modification locale comprend des lacunes induites localement ; ou
dans lequel le matériau de base est un oxyde et dans lequel la modification locale comprend des lacunes d'oxygène induites localement.

14. Réseau matriciel memristif (500) selon la revendication 13,
dans lequel la modification locale du matériau de base comprend en outre des pièges induits localement conçus pour empêcher les lacunes d'oxygène de dériver.

15. Réseau matriciel memristif (500) selon l'une quelconque des revendications 9 à 14,
dans lequel la couche continue du matériau de base (400) comprend au moins une autre partie (430) voisine des parties de matériau memristif (130(i,j)), dans lequel l'au moins une autre partie (430) a une épaisseur qui est supérieure à la plage prédéfinie.
